# EUROPÄISCHE PATENTANMELDUNG

(11) **EP 3 916 766 A2**
(43) Veröffentlichungstag der Anmeldung: **01.12.2021**
(21) Anmeldenummer: 21172264.0
(22) Anmeldetag: 05.05.2021
(51) Int. Cl.: H01L 21/677, B25J 9/16, G06K 9/46, H01L 21/67, G06N 3/04, H01L 21/687

(54) **VERFAHREN ZUR KONTROLLE VON HANDLINGSSYSTEMEN**

(30) Priorität: 05.05.2020 DE 102020112149
(71) Anmelder: Integrated Dynamics Engineering GmbH, 65479 Raunheim (DE)
(72) Erfinder: BIRKNER, Andreas, 07743 Jena (DE)
(74) Vertreter: Blumbach · Zinngrebe Patentanwälte PartG mbB

(57) **Zusammenfassung**

Die Erfindung betrifft ein Verfahren zur Kontrolle von Handlingsystemen, wobei ein rechnerunterstütztes Verfahren zum Bestimmen der Präsenz und/oder der Position und/oder der Orientierung eines Objektes, umfassend ein Substrat, ein Wafer, eine Maske, ein Flat Panel Display, eine Auflage, eine Kassette, eine Bearbeitungsstation oder eine Maschine, zur Anwendung kommt. Die Erfindung betrifft ferner ein zur Ausführung des Verfahrens ausgebildetes System. Das rechnerunterstützte Verfahren kann dabei ein künstliches neuronales Netz umfassen.

## Beschreibung

Die Erfindung betrifft ein Verfahren zur Kontrolle von Handlingsystemen, wobei ein rechnerunterstütztes Verfahren zum Bestimmen der Präsenz und/oder der Position und/oder der Orientierung eines Objektes, umfassend ein Substrat, ein Wafer, eine Maske, ein Flat Panel Display, eine Auflage, eine Kassette, eine Bearbeitungsstation oder eine Maschine, zur Anwendung kommt. Die Erfindung betrifft ferner ein zur Ausführung des Verfahrens ausgebildetes System.

### Hintergrund der Erfindung

Zur Bearbeitung von Substraten, insbesondere von Wafern, Masken oder Flat Panel Displays, können unterschiedliche Handlingsysteme eingesetzt werden. Hierzu gehören beispielsweise Roboter, wobei es gängig ist, dass mittels eines Roboters, welcher einen sogenannten Endeffektor zum Greifen und Ablegen eines Substrates aufweist, die zu bearbeitenden Objekte bzw. Substrate, insbesondere Wafer, Masken oder Flat Panel Displays, von einer Bearbeitungsstation zu einer anderen bewegt werden.

Derartige Roboter bewegen den Endeffektor in der Regel in mehreren Raumrichtungen und es ist bei einer Anlage oder Maschine zur Bearbeitung von Halbleiterbauelementen nötig, den Roboter anzulernen, also die mindestens eine Trajektorie und/oder mindestens eine Zielposition einer Bewegungskurve einzuspeichern.

Bei dem sogenannten "Teach-In" wird ein Roboter mit einem Bewegungsablauf angelernt und/oder mechanisch justiert, welchen er sodann im Betrieb der Anlage weiter ausführt. Insbesondere wird beim Teach-In eine Zielposition angelernt, in welcher das Substrat vom Roboter abgelegt wird. Das Teach-In wird bei vielen Robotern manuell bei angeschalteten Motorachsen durchgeführt. Zumeist erfolgt der Teach-in-Vorgang unter optischer Kontrolle durch einen Bediener und die Bewegungskurve wird durch eine Vielzahl kleinerer Einzelschritte, insbesondere der Radial- und Theta-Bewegungen, durchgeführt. Oft sind dabei zwei Bediener erforderlich, da beim Teach-In-Vorgang zwei oder mehr Richtungen oder Freiheitsgrade optisch überwacht werden müssen, um Kollisionen zu vermeiden.

Bei Fehlern des Bedieners können größere Schäden entstehen. Zudem ist die Sicht des Bedieners, der die Bewegung des Roboters optisch überwacht, vielfach eingeschränkt. Dies gilt insbesondere in Vakuum-Kammern.

Weiterhin ist der Vorgang des Teach-In, oder der vorzugsweise regelmäßig durchgeführten Kontrolle des korrekten Teach-In zumeist damit verbunden, dass die Anlage geöffnet werden muss, wodurch sie außer Betrieb genommen werden muss, was entsprechende Ausfallzeiten erzeugt. Es muss dazu das sogenannte Mini-Environment der Anlage geöffnet werden, wodurch die Anlage verunreinigt werden kann, was wiederum zusätzliche Ausfallzeiten der Maschine verursacht, um danach die erforderliche Sauberkeit in der Anlage wiederherzustellen.

Ein ungenaues Teach-In führt kann zu erhöhter Partikelgenerierung führen und damit zu verringerter Ausbeute des Prozesses, in welchem die Anlage verwendet wird. Ungenaues Teach-In kann ebenfalls zu Fehlern durch zu große Fehlablagen des Substrats führen.

Aus dem Dokument EP 19 206 746.0 der Anmelderin sind Verfahren zum Anlernen oder Kontrollieren eines Roboters zum Bewegen eines Wafers oder einer Maske oder eines Flat-Panel Displays bekannt, wobei Kameras und eine regelbasierende Bildverarbeitung genutzt werden zum Erkennen von Objekten, insbesondere von Substraten wie Masken (Reticle), Wafern oder Flat Panel Displays.

Diese Verfahren können zusammen mit oder in Maschinen oder Anlagen der Halbeiterindustrie, welche zur Prozessierung von Wafern, Masken oder Flat Panel Displays verwendet werden, genutzt werden.

Dabei soll mittels an den Maschinen oder Anlagen angebrachter Kameras, etwa einer an einem Endeffektor angebrachten Kamera oder auch mittels am Ablageort angebrachter Kameras oder an anderer Stelle angebrachter Kameras ermittelt werden, ob sich die besagten Objekte an einer bestimmten Stelle befinden.

So soll beispielsweise die Belegung einer Kassette mit Substraten ermittelt werden können. Ferner soll ermittelt werden können, in welcher Orientierung hinsichtlich der jeweils drei translatorischen und rotatorischen Freiheitsgrade sich diese Objekte befinden, ob sie sich in einer vorbestimmten Position befinden, und in welcher Konfiguration diese Objekte vorliegen.

Hier stellt sich etwa die Frage, ob eine Maske mit oder ohne einem sogenannten "Pellicle" ausgebildet ist, und wenn ja, ob das Pellicle oben oder unten auf der Maske sitzt, ferner auch, in welcher Orientierung das Pellicle vorliegt.

Dabei erzeugt die Kamera Bilder, welche manuell /visuell ausgewertet werden können. Hierzu kann eine Bildverarbeitung genutzt werden.

Diese Art der Bildverarbeitung beruht auf dem Verfahren, geometrische Objekte, oder geometrische Eigenschaften von Objekten, oder auch Formen von Objekten zu erkennen, indem Regeln definiert werden, nach denen diese Eigenschaften von Objekten erkannt werden können.

Beispielsweise kann die Lage einer Objektkante dadurch bestimmt werden, dass die zu erkennende Kante eines Objektes einen Farbunterschied von der Kante zu einem Hintergrund aufweist, welcher durch die Bilderkennung dadurch erkannt wird, dass eine Regel definiert ist, welche die Farbwerte der Kante und des Hintergrundes definiert, und den Übergang der Farbwerte vom Objekt zum Hintergrund als einen Punkt der Kante definiert. Werden beispielswiese mehrere solche Regeln auf verschiedene Stellen eines Objektes angewandt, können damit auch mehrdimensionale Objekte auf ihre Form, ihre Lage, und ihre Anwesenheit bestimmt werden.

Dabei werden geeignete Regeln in diskreten vordefinierten Abschnitten des Bildes eines Objektes definiert. Die Bildverarbeitung kann dann demzufolge auch nur korrekt arbeiten, wenn sich das Objekt in diesen vordefinierten Abschnitten befindet. Nach diesem Verfahren arbeitende Systeme werden häufig auch als regelbasierende Verfahren bezeichnet.

Der Nachteil solcher regelbasierenden Verfahren ist es, dass durch die Regeln die in der betrieblichen Praxis auftretenden Schwankungen und Einflussfaktoren berücksichtigt werden müssen.

Dies kann sehr komplex werden, wenn verschiedene Einflussfaktoren zu berücksichtigen sind. So kann es beispielsweise vorkommen, dass bei der Erkennung eines Objektes wie beispielsweise einer Maske, oder der Bestimmung der Position oder der Größe des Objektes, verschiedene Beleuchtungsverhältnisse, verschiedene Farben der Objekte und des Hintergrundes, unterschiedliche Bildschärfen, beispielsweise auch infolge von auftretenden Vibrationen während der Bildaufnahme, Lichteinstreuungen aus der Umgebung oder auch Toleranzen der Position oder der Lage des Substrates oder der Kamera zu berücksichtigen sind.

Diese Aufzählung ist rein beispielhaft zu sehen und wird nicht als vollständig erachtet. So können in komplexen Produktionsumgebungen weitere Einflussfaktoren hinzukommen. Erschwerend kann hinzutreten, dass auch noch zusätzliche Einflussfaktoren erst während der späteren Verwendung des Verfahrens in den Systemen hinzutreten können, beispielsweise im Jahresrhythmus variierende Lichtverhältnisse.

Dies kann zu sehr komplexen Regelwerken führen, in welchen die zumeist manuell erstellten Regeln aufgeführt werden.

Allerdings sind diese mit steigender Komplexität immer aufwendiger zu definieren, und können zudem auch immer unzuverlässiger arbeiten, da die Anzahl der Regeln über die Kombination der verschiedenen Schwankungen sehr hoch werden kann und dadurch eine entsprechend hohe Anzahl von Fehlerquellen entstehen.

Weiterhin sind diese Regeln nicht oder kaum flexibel. So kann eine in einer definierten Regel nicht vorgesehene Schwankung, beispielsweise hervorgerufen durch eine sich ändernde Lichteinstreuung aus der Umgebung des Systems, leicht zu Fehlfunktionen der Bilderkennung führen.

Da zumeist die Regeln in diskreten vordefinierten Abschnitten des Bildes eines Objektes definiert sind, kann die Bildverarbeitung demzufolge nur dann korrekt arbeiten, wenn sich das Objekt in diesen vordefinierten Abschnitten befindet.

Weiterhin kann es auch vorkommen, dass - unabhängig von den Einflussfaktoren - über zumeist manuell erstellte Regeln eine Erkennung generell nicht sinnvoll oder möglich ist, weil von vornherein für die Erkennung eines Objektes zu viele Regeln benötigt werden.

Nochmals erschwerend kommt hier hinzu, dass sich das Objekt auch an verschiedenen Stellen befinden kann, beispielsweise ein Wafer nur in einem bestimmten Ablageort einer Kassette.

Zum Beispiel kann es zu einer Fehlablage einer Maske auf einer Ablage in einem System zur Bearbeitung von Halbleitermasken kommen, wenn beispielsweise die Maske von einer Auflage abgerutscht ist, und an einer Stelle liegt, die von den definierten Regeln einer regelbasierenden Bildverarbeitung nicht berücksichtigt sind.

In diesem Fall wird durch die regelbasierende Bildverarbeitung nicht erkannt, dass zwar eine Maske vorhanden ist, aber in einer Fehllage liegt. Dies kann zu einem Fehlverhalten des Handlingsystems führen, zum Beispiel zu einer Kollision eines Endeffektors eines Roboters mit der Maske, und damit zu einem größeren wirtschaftlichen Schaden führen.

Auch können beispielsweise Abstände nicht mehr korrekt bestimmt werden, wenn ein Roboter, bei welchem eine Kamera auf dem Endeffektor installiert ist, beim Teach-In eine starke Positionsabweichung zu einer vordefinierten Position aufweist.

Zwar ist beispielsweise aus der EP 1 366 867 B1 ein Verfahren zum Vermeiden von Kollisionen zwischen einem Roboter und wenigstens einem anderen Objekt bekannt, wobei eine Anhaltezeit für eine Roboterbewegung bestimmt wird und wobei eine Behinderungsüberprüfung mittels eines neuronalen Netzes geschieht.

Ferner ist aus der EP 3 409 230 B1 ein Verfahren zum Bewegen eines Roboterarms bekannt, wobei ein künstliches neuronales Netz zur Verfügung gestellt wird, welches genutzt wird, um einen optimalen Bewegungsablauf für einen Roboter im Zuge einer Ultraschalluntersuchung zu finden.

Auch mit diesen Verfahren ist es aber nicht möglich, beispielsweise zu verhindern, dass es zu einer Kollision zwischen einem Handlingsystem und einem Objekt kommt, welches sich etwa ungeplant in einer vorgesehenen Bewegungsbahn des Handlingsystems oder sich an einem Ort befindet, an dem es sich bei fehlerfreien Betrieb nicht befinden würde.

### Aufgabe der Erfindung

Die Erfinder haben sich daher die Aufgabe gestellt, ein Verfahren zur Kontrolle oder Steuerung von Handlingsystemen zur Verfügung zu stellen, welches ein Handlingsystem im Sinne einer Kollisionsvermeidung kontrollieren und eine vorgesehene Bewegungsbahn des Handlingsystems einstellen und/oder verbessern kann.

Von daher wird es als wünschenswert angesehen, ein Verfahren zur Kontrolle oder Steuerung von Handlingsystemen und ein System anzugeben, welches die weiter oben genannten Nachteile vermeidet.

Das Verfahren soll dabei in Handlingsystemen, etwa im Bereich von Maschinen der Halbleiterindustrie, einem Roboter oder einer Verfahreinheit, verwendet werden können, beispielsweise zur Kontrolle oder Steuerung des Handlingsystems.

Das Verfahren soll es beispielsweise ermöglichen, zu erkennen, ob sich bestimmte Objekte an einer bestimmten Stelle befinden. Ferner soll ermittelt werden können, ob sich diese Objekte in einer Position und Orientierung befinden, in welcher sie bewegt oder prozessiert werden können. Es soll auch ermittelt werden können, ob sich Objekte unvorhergesehen an einem Ort befinden.

Vorzugsweise soll dabei vermieden werden, dass für den Ablauf des Verfahrens manuell von einem Bediener vielfältig Regeln und Bedingungen definiert werden müssen.

Wünschenswert ist demnach also eine Abkehr von einem starren, regelbasierenden Verfahren hin zu einem Verfahren, welches eine hohe Flexibilität bei gleichzeitig niedrigem Aufwand bietet.

### Zusammenfassung der Erfindung

Die Aufgabe der Erfindung wird bereits durch ein Verfahren zur Kontrolle oder Steuerung von Handlingsystemen, ein zur Ausführung dieses Verfahrens ausgebildetes System sowie ein Computerprogrammprodukt nach einem der unabhängigen Ansprüche gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft demnach ein Verfahren zur Kontrolle oder Steuerung eines Handlingsystems, wobei mindestens ein Bild, welches einen Ort in oder an dem Handlingsystem oder in der Umgebung des Handlingsystems darstellt, in digitalisierter Form von einem künstlichen neuronalen Netz erfasst wird, und wobei durch das künstliche neuronale Netz das Bild analysiert und ein Informationsdatensatz erzeugt und/oder ein Steuerbefehl generiert wird, mit welchem das Handlingsystem direkt oder unterstützend gesteuert, ausgerichtet, trainiert, und/oder kontrolliert wird.

Das Handlingsystems kann dabei ein System oder eine Maschine umfassen, wie es typischerweise an oder in Verbindung mit einer Maschine der Halbleiterindustrie zur Anwendung kommen kann. Das Handlingsystem kann dabei ausgebildet sein oder Mittel umfassen zum Greifen, Haltern, Transportieren und/oder Ablagen eines Substrates, zum Beispiel, um ein Substrat zwischen zwei oder mehreren Stationen, beispielsweise einer Auflage oder einer Bearbeitungsstation, zu bewegen.

Unter dem Begriff Handlingsystem ist im Sinne der Erfindung zumindest ein Anlagenteil eines Systems der Halbleiterindustrie oder einer Maschine der Halbleiterindustrie zu verstehen, oder auch das System oder die Maschine als Ganzes, wobei das System oder die Maschine vorzugsweise zur Bearbeitung oder zum Prozessieren von Wafern, Masken oder Flat Panel Displays ausgebildet ist und eingesetzt wird.

Ein Anlagenteil kann demnach weiterhin umfassen
- Einrichtungen zum Transport eines Substrates innerhalb der Maschine, z.B. ein Roboter, Endeffektoren, Greifer, Vacuum-Chucks, Stages, Tracks,
- Bearbeitungsstationen, auf welchem beispielsweise die Orientierung eines Substrates geändert werden kann, wie eine horizontale oder vertikale Rotation,
- Bearbeitungsstationen, auf welchen die Orientierung und die Position eines Substrates geändert werden kann, z.B. Prealigner
- Eingabestationen, die das Interface zur Halbleiterfabrik darstellen (Loadports),
- Transportmittel für Substrate wie Kassetten, Ablagen, Auflagen, Fixiereinrichtungen, Klemmungen, Vakuum-Ansaugeinrichtungen, Bernoulli-Systeme, Vakuumkammern, Schleusen, Pumpen, Ventile
- Speicher, wo mehrere Substrate abgelegt werden
- Sensoren, beispielsweise zur Erkennung der Substrat-Identifikation oder Identifikation von Transportbehältern und Kassetten
- Sensoren zur Erkennung von Substraten oder von Komponenten des Handlingsystems, z.B. Lichtschranken, kapazitive Abstandssensoren, Reflexkoppler
- Markierungen, die durch Sensoren erkannt werden können, z.B. Reflexionsflächen für Reflex-Sensoren, lichtstrahlunterbrechende Elemente für Lichtschranken
- Rahmen, Befestigungselemente, Verkleidungen, welche teilweise auch durch Sensoren überwacht werden können, ob sie beispielweise geschlossen sind
- Mechanische Interfaces zum Reinraumboden und zur Maschine
- Mini-Environment zu Sicherstellung der Reinraumklasse, bestehend aus Filter-Fan-Einheit, Verkleidungen, Luftführungen, Absaugeinrichtungen
- Sicherheitseinrichtungen, für Human-Safety und Material-Safety, wie manuelle oder automatische Türen, Sensoren, Lichtschranken, Abschalteinrichtungen, wobei beispielsweise durch einen Sensor überwacht wird, ob eine durch eine Tür schließbare Kassette für die Ablage eines Substrates geöffnet ist,
- Service-Einrichtungen wie Auszüge für schwere Teile
- Schnittstellen zur Fabrik, wie zum Beispiel zu automatische Transporteinrichtungen für Transportbehälter, wo beispielsweise überwacht wird, ob eine Kassette auf einem Ablageplatz der Maschine frei ist für das Absetzen einer Kassette
- Bedienelemente, Tastaturen und Displays, wo beispielsweise auf Displays das Vorhandensein eines Substrates auf einer Ablage oder die Position eines Roboters angezeigt werden kann
- Steuerung des Handlingsystems, Controller, zentrale oder dezentrale Steuerungen der einzelnen Komponenten, soweit sie steuerbar sind, mit der Steuer-Hardware (Rechner)und der Software (Betriebssystem, Anwendersoftware und Softwarekomponenten verschiedenster Art), wobei die Software zumindest teilweise auch auf Rechnern laufen kann, welche nicht direkt zum Handlingsystem gehören (zum Beispiel auf dem Rechner der gesamten Halbeitermaschine, oder / und auf dem Rechner der Fabrik, in dem die Maschine steht, oder auf einem anderen Rechner, welcher Informationstechnisch mit dem Handlingsystem verbunden ist

Insbesondere kann mit einem Handlingsystem ein Roboter bezeichnet sein, welcher ein bewegliches Element, bevorzugt einen Roboterarm und/oder einen Endeffektor, umfassen kann. Ferner kann unter dem Begriff Handlingsystem insbesondere auch eine Verfahreinheit verstanden werden, welche zum Greifen, Transportieren und/oder Ablegen eines Substrates verwendet werden oder hierzu geeignete Mittel aufweisen kann.

Das Handlingsystem kann dabei auch in Verbindung mit oder in einer Vakuumkammer zum Einsatz kommen, etwa in Verbindung mit oder in einer Vakuumkammer für Wafer, Masken oder Flat Panel Display, oder auch mit oder an einem dort installierten Vakuum-Roboter, Vakuum-Stage oder Vakuum-Chuck.

Im Sinne der Erfindung sieht das Verfahren weiterhin vor, dass mindestens ein Bild, welches einen Ort in oder an dem Handlingsystem oder in der Umgebung des Handlingsystems darstellt, in digitalisierter Form von einem künstlichen neuronalen Netz erfasst wird.

Unter dem Begriff "Bild" wird im Sinne der Erfindung auch ein digitalisiertes Bild oder eine digitalisierte Darstellung eines analogen Bildes oder einer analogen Abbildung verstanden. Das Bild kann vorzugsweise einen Ort oder Bereich in oder an dem Handlingsystem oder in der Umgebung des Handlingsystems abbilden oder darstellen, an dem sich ein Substrat bei einem bestimmungsgemäßen Betrieb befinden kann. Vorzugsweise handelt es sich hierbei um Orte, an denen das Vorhandensein eines Substrates erwartbar ist.

In anderen Worten, das analoge Bild kann einen Ort abbilden, an welchem sich bei einem fehlerfreien Betrieb des Handlingsystems ein Substrat befinden sollte. Das analoge Bild kann also auch ein Substrat abbilden.

Der Ort kann typischerweise etwa eine Ablage für Substrate sein oder ein Speicher für Substrate, etwa eine Kassette für die Aufnahme und Speicherung von Wafern. Es kann aber auch ein Ort im Umfeld des Handlingsystems, etwa ein Bereich in der Bewegungsbahn des Handlingsystems sein, welcher während des Transportes des Substrates überquert werden kann. Hier kann es beispielsweise vorkommen, dass sich ein nicht ordnungsgemäßes gehaltertes Substrat während des Transportes löst und auf den Boden oder auf Anlagenteile der Maschine auftrifft.

Das Bild kann also ein Substrat an einem Ort zeigen, welches ordnungsgemäß und fehlerfrei abgelegt ist. Genauso kann es aber auch ein nicht fehlerfrei abgelegtes Substrat in einer sogenannten Fehllage an diesem oder einem anderen Ort zeigen, also ein nicht fehlerfrei aufgelegtes Substrat, oder auch einen leeren Aufnahmeort, wenn etwa das Substrat an einem anderen Ort abgelegt wurde oder während des Ablegens abgerutscht ist.

Der Ort kann demnach einen Bereich in dem Handlingsystem zeigen, an dem sich Wafer und/oder Masken und/oder Flat Panel Displays und/oder Auflagen und/oder Kassetten und/oder Markierungen, und/oder Teilen des Handlingsystems bei fehlerfreien Betrieb und/oder bei nicht fehlerfreien Betrieb des Handlingsystems befinden und/oder befinden können.

Das Bild kann dabei neben einem Einzelbild auch ein oder mehrere Einzelbilder, beispielsweise aus Videos, oder auch Videosequenzen, umfassen.

Das zumindest eine Bild kann dabei durch eine Aufnahmeeinheit aufgenommen und in digitalisierter Form dem künstlichen neuronalen Netz zur Verfügung gestellt werden, was bedeutet, dass das Bild quasi "online" im Betrieb des Handlingsystems erzeugt wird. Es kann aber auch quasi "offline" aus einer Datenbank dem künstlichen neuronalen Netz zur Verfügung gestellt werden.

Das künstliche neuronale Netz kann dieses Bild in digitalisierter Darstellung erfassen und analysieren, also für eine Detektion und Klassifikation verwenden, um einen Informationsdatensatz und/oder einen Steuerbefehl zu erzeugen, mit welchem das Handlingsystem direkt oder unterstützend gesteuert, ausgerichtet, trainiert, und/oder kontrolliert wird. Selbstverständlich ist es nicht nur möglich, das Bild als Ganzes zu analysieren, sondern auch nur einen Ausschnitt des Bildes.

Dies bedeutet, dass das Handlingsystem und/oder zumindest eine Komponente des Handlingsystems, beispielsweise ein Roboter oder ein Endeffektor, zueinander ausgerichtet und/oder justiert und/oder trainiert werden kann.

Dies kann manuell durchgeführt werden kann, wenn einem Bediener die Informationen bereitgestellt werden, und/oder zumindest teilweise automatisch durchgeführt werden, indem die Maschine selber die Informationen des Informationsdatensatzes weiterverwendet, und selbstständig das Handlingsystem und/oder die Komponente des Handlingsystems mit den einzustellenden Werten konfiguriert, beispielsweise mit Positionsdaten eines Roboters , so dass sich das Handlingsystem zumindest teilweise selbständig automatisch ausrichten, justieren oder trainieren kann. Auch Kombinationen sind möglich.

Es kann aber auch das Handlingsystem im Betrieb fortlaufend oder in bestimmten Abständen kontrolliert werden, ob die eingestellte Ausrichtung, die Justierung oder das Teaching noch innerhalb definierter Grenzen liegt, und das Ergebnis der Kontrolle einem Bediener anzeigt werden, der dann bei unzulässigen Abweichungen von Sollwerten Maßnahmen einleiten kann, und/oder die Steuerung der Maschine die Informationen auswertet, die dann selbständig Maßnahmen einleiteten kann, und/oder die Steuerung der Maschine die Informationen auswertet, und ein selbstständiges neues Ausrichten, Justieren oder Trainieren durchführt, und/oder
die Informationen an ein übergeordnetes Steuerungssystem weitergegeben werden, und/oder die Information für eine Prozesskontrolle verwendet wird, und/oder die Information für eine weitere Verwendung gespeichert wird, und/oder
die Daten für die Planung eines nächsten Wartungseinsatzes verwendet werden.

Ferner können mittels des künstlichen neuronalen Netzes auch Maschinenteile, welche ein Hindernis im Bewegungsbereich von Komponenten des Handlingsystem bilden können, erkannt werden. Hierzu gehören beispielsweise nicht geöffnete Türen bei Übergabe eines Wafers, einer Maske oder eines Flat Panel Displays in eine Vakuumkammer. Dazu gehören auch beispielsweise eine nicht geöffnete Wafer-Kassette, aus welcher ein Wafer entnommen werden soll.

Die Information kann für manuelle oder automatische abzuleitende Maßnahmen verwendet werden, beispielsweise ein Stopp des Handlingsystems, und oder es kann erkannt werden, ob an der Stelle, wo ein Wafer, eine Maske oder ein Flat Panel Display abgelegt werden soll, sich bereits ein Wafer, eine Maske oder ein Flat Panel Display befindet.

Es kann beispielsweise auch erkannt werden, ob sich an der Stelle, wo ein Wafer, eine Maske oder ein Flat Panel Display aufgenommen werden soll, sich ein Wafer, eine Maske oder ein Flat Panel Display befindet, und ob diese sich in der richtigen Lage und Orientierung befindet oder in einer Fehllage.

Bei der Fehllage kann es sich beispielsweise um ein "double slotted" Wafer oder einen "cross slotted" Wafer handeln, wobei im ersten Fall zwei Wafer an oder in einer Ablage liegen, und im zweiten Fall ein Wafer schräg über mehrere Ablagen verteilt liegt und damit nicht korrekt aufliegt.
Die Information kann weiterhin für manuelle oder automatische abzuleitende Maßnahmen verwendet werden.

Die Information kann auch dazu dienen, zu erkennen ob benötigter Bereich frei von Hindernissen ist, oder ob sich nicht zur Maschine gehörende Objekte im Bereich befinden, beispielsweise eine Extremität eines an der Maschine arbeitenden Bedieners, woraufhin die Information für manuelle oder automatische abzuleitende Maßnahmen verwendet wird.

Die Information kann auch genutzt werden, um zu erkennen, ob ein für einen Handlingsvorgang benötigter Bereich frei von Hindernissen ist, oder ob sich auch nicht zur Maschine gehörende Objekte im Bereich befinden, beispielsweise eine Extremität eines an der Maschine arbeitenden Bedieners.

Bei einem künstlichen neuronalen Netz handelt es sich insbesondere um ein in einem Computerprogramm abgebildetes Netz aus künstlichen Neuronen, welche miteinander vernetzt sind. Hierbei können sie auf verschiedenen Schichten oder Hierarchiebenen, sogenannten "Layern", angeordnet sein.

Unter dem Begriff künstliches neuronales Netz werden im Sinne der Erfindung eine oder mehrere Schichten neuronaler Layer verstanden, und/oder eine oder mehrere Schichten "Convolutional-Layer", auch "Convolution Layer" genannt, mit ihren Verbindungen und/oder Gewichtungen und/oder weiteren Layern und/oder dem Netzwerk zugeordneten Bestandteilen wie beispielsweise Filtern, Aktivierungen, Gewichtungen, "Pooling_Layern" oder Rückkopplungen, welche in der Lage sind, Eingangsdaten aufzunehmen, und im Zusammenspiel mit gelernten Daten, Ausgangsdaten daraus zu generieren.

Hierzu kann ein Modell eines künstlichen neuronalen Netzes erstellt werden, welches dann in einer Trainingsphase trainiert werden kann. Durch das Training können Verbindungen zwischen künstlichen Neuronen und/oder den Layern gewichtet werden, oder es können weitere Parameter ermittelt werden, welche die Erzeugung des Informationsdatensatzes durch das Netz steuern. Auf diese Weise kann ein trainiertes künstliches neuronales Netz zur Verfügung gestellt werden. Das künstliche neuronale Netz kann auch Verzweigungen aufweisen, oft auch als sogenannte "skip-connections" bezeichnet, was beispielsweise bei komplexeren Aufgabenstellungen Anwendung finden kann.

Ein für die Erfindung geeignetes künstliches neuronales Netz ist dazu ausgebildet, dass es beispielsweise ein bestimmtes Objekt, beispielsweise ein Substrat, in Bildern erkennen kann in einem Bild, welches unter anderem dieses Objekt abbildet, und darauf trainiert wurde, ein solches Objekt zu erkennen. In weiteren Ausführungsformen können beispielsweise auch Orientierungen, Positionen oder Abmessungen von Objekten zumindest ungefähr erkannt werden.

Solche künstlichen neuronalen Netze oder Netzwerke sind für verschiedene Aufgabenstellung in verschiedenen Konfigurationen bekannt, beispielsweise, je nach Konfiguration, als CNN-Netzwerk (CNN = "Convolutional" Neuronales Netzwerk), oder KNN-Netzwerk (KNN = "Künstliches Neuronales Netzwerk"), FCN-Netzwerk (FCN = "Fully Convolutional" Netzwerk), RNN-Netzwerk (RNN = "Recurrent" Neuronales Netzwerk) und andere.

Solche künstlichen neuronalen Netzwerke können in ihrer Konfiguration oder im Aufbau an verschiedene Aufgabenstellungen angepasst werden, und werden typischerweise vor dem Einsatz trainiert oder angelernt, können aber auch ergänzend oder alternativ bereits existierende Lerndaten oder vorgelernten Lerndaten übernehmen. Es gibt verschiedene Implementierungsmöglichkeiten solcher Netzwerke, wie beispielsweise "Tensor Flow" oder "Keras".

Das künstliche neuronale Netz kann mindestens ein Modell ausbilden, welches mindestens eine Faltungsebene (Convolutional Layer) und/oder mindestens eine Neuronenebene (Neuronal Layer) umfasst. Dabei kann es weiterhin vorzugsweise zumindest einen der folgenden Bestandteile umfassen: einen Aktivierungs-Layer, einen Pooling-Layer, einen Flatten-Layer, einen Drop-Layer. Von Vorteil umfasst das künstliche neuronale Netz Daten zur Gewichtung von mindestens einem, bevorzugt mehreren und besonders bevorzugt allen gewichtbaren Bestandteilen des Modelles. Diese Gewichtung kann dabei besonders einfach durch einen Trainingsvorgang bestimmt werden.

Ferner kann das künstliche neuronale Netz zumindest eine der Methoden der Regression, "Machine-Learning" oder "Deep-Learning" verwenden.

Der Lernvorgang solch künstlicher neuronaler Netze wird oft auch als selbstadaptiver Algorithmus oder als "Maschine Learning" verstanden. Wenn eine Reihe von Hierarchiebenen bzw. "Layern" verwendet wird, so wird dies auch als "Deep-Learning" bezeichnet, wobei die dafür Anzahl der "Layer" nicht genau definiert ist.

Es versteht sich, dass im Rahmen der Erfindung für das Verfahren zur Kontrolle oder Steuerung von Handlingsystemen vorzugsweise ein trainiertes oder angelerntes künstliches neuronales Netz verwendet wird.

Im Sinne der Erfindung kann ein derartiges trainiertes künstliches neuronales Netz einen Informationsdatensatz mit zumindest einer Information generieren, welcher zur Kontrolle und/oder Steuerung des Handlingsystems genutzt werden kann, oder es kann hierauf basierend ein Steuerbefehl erzeugt werden, welcher die Steuerung des Handlingsystems unterstützt. Das Handlingsystem kann damit direkt oder unterstützend gesteuert, ausgerichtet, trainiert, und/oder kontrolliert werden.

Im Sinne der Erfindung ist das künstliche neuronale Netz ausgelegt für eine Bestimmung der Präsenz und/oder der Position und/oder der Orientierung eines Objektes im Bild, insbesondere eines Substrates, eines Wafers, einer Maske, eines Flat Panel Display, oder eines Teiles des Substrates, einer Auflage, einer Kassette, einer Bearbeitungsstation oder einer Maschine oder eines Teiles eines Objektes, oder einer Markierung,
und/oder für eine Klassifikation zur Bestimmung der Art des Objektes,
und/oder für eine Bestimmung des Abstands zwischen zumindest zwei Objekten,
und/oder für eine Bestimmung der Position des Objektes in Bezug auf einen Bezugspunkt des Handlingsystems,
und/oder für eine Bestimmung der Abmessung des Objektes.

Die Position eines Objektes kann dabei die Position des Objektes oder eines Teiles des Objektes zu einem in der Maschine feststehenden oder beweglichen Bezugspunkt sein,
und/oder die Position des Objektes in Bezug auf eine Aufnahmeeinheit, die feststehend in oder an dem Handlingsystem installiert ist oder sich auf einem beweglichen Teil befindet, wie beispielsweise an einem Roboter, oder an einem Arm des Roboters, oder an einem Endeffektor, und/oder die Position in Bezug auf ein anderes Objekt.

Ergänzend können für die Bestimmung der Position und/oder der Orientierung und/oder der Abstände von Objekten und/oder der Aufnahmeeinheit und/oder von Bezugspunkten im Raum geometrische Verfahren eingesetzt werden, beispielsweise eine Triangulation, wobei dann diese Information mit Information des künstlichen neuronalen Netzes kombiniert werden können.

Eine Klassifikation zur Bestimmung der Art des Objektes meint damit eine Bestimmung des Objektes, ob es sich bei einem erkannten Objekt beispielsweise um einen Wafer, eine Maske, ein Flat Panel Display, oder eine Auflage, oder eine Kassette, oder eine Markierung, oder ein Maschinenteil, oder ein Teil des Handlingsystems handelt. Ein Objekt kann demnach auch ein Substrat und/oder ein Teil davon, und/oder einen Teil der Maschine und/oder einen Teil des Handlingsystems umfassen.

Die Bestimmung des Abstands zwischen zumindest zwei Objekten meint dabei einen Abstand in mindestens einem oder allen drei translatorischen Freiheitsgraden und/oder Abstände in mindestens einem oder allen drei rotatorischen Freiheitsgraden. Dies können beispielsweise Abstände sein zwischen Wafern und/oder Masken und/oder Flat Panel Displays, oder jeweils von Teilen davon, oder Abstände zwischen Auflagen und/oder Kassetten und/oder Markierungen, oder jeweils von Teilen davon, oder Abstände zwischen Teilen der Maschine, oder Abstände zwischen der Aufnahmeeinheit. Unter Teilen von Wafern und/oder Masken und/oder Flat Panel Displays sind dabei auch zusätzliche Aufbauten an diesen Substraten zu verstehen, beispielsweise eine Kalibiereinrichtung, ein Messmittel oder ähnliche Bauteile, aber auch Halterungen, zum Beispiel Substrathalter, welche ein Substrat haltern können.

Die Bestimmung der Position des Objektes kann in Bezug auf einen Bezugspunkt des Handlingsystems erfolgen. Der Bezugspunkt kann dabei in Bezug auf das Handlingsystem feststehend oder beweglich sein.

Die Bestimmung der Abmessung eines Objektes betrifft beispielsweise die Abmessung von Wafern und/oder Masken und/oder Flat Panel Displays, oder Teilen davon, oder Auflagen und/oder Kassetten und/oder Markierungen, und/oder von Teilen der Maschine.

Damit kann dann durch das künstliche neuronale Netz ein Informationsdatensatz erzeugt werden, umfassend eine Information
über die ermittelte Präsenz oder Position oder Orientierung eines Objektes im Bild,
oder über die Art des Objektes im Bild, insbesondere das Vorhandensein von Auflagen, Kassetten, oder von Teilen, oder von Markierungen, Aufklebern, Beschriftungen oder Referenzmarken,
oder über mögliche Hindernisse im Bewegungsbereich des Handlingsystems wie Türen oder Loadlocks,
oder über das Vorhandensein von Bearbeitungsstationen
oder über den Abstand zwischen zumindest einem Objekt im Bild zu einem Bezugspunkt des Handlingsystems,
oder über die Position des Objektes im Bild,
oder über die Abmessung des Objektes im Bild.

Dieser Informationsdatensatz kann dazu genutzt werden, das Handlingsystem direkt zu steuern, oder er kann von der Steuerung des Handlingsystems verwendet werden. Der Informationsdatensatz kann auch an ein übergeordnetes Steuerungssystem weitergegeben werden.

Der Informationsdatensatz kann zum Beispiel einen Steuerbefehl umfassen oder generieren, welcher eine Anweisung umfasst zum Bewegen des Handlingsystems, beispielsweise zum Bewegen eines Roboters und/oder des beweglichen Elements des Roboters, bevorzugt des Roboterarms oder des Endeffektors des Roboters, oder einer Verfahreinheit.

So kann zum Beispiel der Endeffektor zu einem Slot einer Kassette für Wafer bewegt werden. Über die Erkennung der Position der Ablageposition in der Kassette, und der Position des Roboters kann die zu bewegende Strecke bestimmt werden, und ein Steuerbefehl an den Roboter gegeben werden. Der Steuerbefehl kann auch eine Anweisung zum Greifen des Substrates, zum Transportieren des Substrates zu einem vorgesehenen Ablageort und/oder Ablegen des Substrates an dem vorgesehenen Ablageort umfassen.

Der Informationsdatensatz kann auch an einen Bediener weitergegeben werden, etwa drahtlos an eine Anzeigeeinheit oder ein Display, so dass der Bediener dann aus dieser Information Rückschlüsse für sein Handeln zur Bedienung der Maschine ziehen kann. Der Bediener kann ferner diese Information an Steuerungen oder andere Bediener weitergeben, oder der Informationsdatensatz kann für spätere oder weitere Auswertung gespeichert werden.

Der durch das künstliche neuronale Netz erzeugte Informationsdatensatz umfasst zumindest eine Information, aus welcher die Präsenz eines Objektes insbesondere eines Substrates, Wafers, Maske oder Flat Panel Display in einem Slot, oder auf einer Auflage, oder auf einem Roboter, oder auf einem Endeffektor, oder auf einer Bearbeitungsstation in der Maschine, oder an einem anderen Ort, wo sich das Objekt in der Maschine der Halbleiterindustrie befinden kann, ermittelt werden kann oder ableitbar ist.

Dies betrifft auch das Vorhandensein von Auflagen, Kassetten, oder von Teilen hiervon durch die Klassifikation des Objektes, also die Bestimmung der Art eines aufgefundenen Objektes, oder das Vorhandensein von Markierungen, wie beispielsweise Aufklebern, Beschriftungen oder Referenzmarken.

Ferner betrifft dies auch das Vorhandensein von Teilen der Maschine, beispielsweise die Auflagen eines Endeffektors, oder von möglichen Hindernissen im Bewegungsbereich des Handlingsystems wie Türen, "Loadlocks" oder ähnliches, aber auch das Vorhandensein von Bearbeitungsstationen der Maschine.

Der Informationsdatensatz kann auch zumindest eine Information umfassen, aus welcher die räumliche Orientierung des Substrates in Bezug auf die zu einem Roboter der Maschine gerichtete Seite eines Slots, oder in Bezug zu einer Auflage, oder in Bezug zu einer Bearbeitungsstation, oder in Bezug zu einem anderen Teil der Maschine, ermittelt werden kann oder ableitbar ist.

Ferner kann der Informationsdatensatz auch zumindest eine Information umfassen, aus welcher die räumliche Lage des Substrates zu einem Slot, oder zu einer Auflage, oder zu einem Roboter, oder zu einem Endeffektor, oder zu einem anderen Ort, wo sich das Substrat in der Maschine der Halbleiterindustrie befinden kann, ermittelt werden kann oder ableitbar ist.

Ferner kann der Informationsdatensatz beispielsweise auch zumindest eine Information umfassen, aus welcher die Präsenz eines Pellicles auf einem Substrat, insbesondere auf einer Maske, und/oder die Seite, also die Oberseite oder die Unterseite eines abgelegten Substrates, insbesondere einer Maske, auf der sich ein Pellicle befindet, ermittelt werden kann oder ableitbar ist.

Ferner kann der Informationsdatensatz auch zumindest eine Information umfassen, aus welcher die Orientierung eines Pellicles in Bezug zu einer Referenzachse einer Auflage, einer Kassette, eines Roboters, eines Endeffektors, ermittelt werden kann oder ableitbar ist.

Schließlich kann der Informationsdatensatz auch zumindest eine Information umfassen, aus welcher die Präsenz und/oder die Position und/oder die Orientierung eines Substrates, ermittelt werden kann oder ableitbar ist. Unter Präsenz eines Substrates ist hierbei auch zu verstehen, dass der Typ des Substrates erkannt wird, ob das Substrat also ein Wafer, oder eine Maske, oder ein Flat Panel Display ist.

Ein wichtiger Aspekt der Erfindung ist darin zu sehen, nicht nur die Erkennung eines Objektes durchzuführen, also seine Präsenz, oder seine Orientierung zu ermitteln, sondern auch seine Position im Bewegungsbereich des Handlingsystems zu ermitteln, insbesondere zumindest seine ungefähre Position mittels Detektion. Hierzu wird erfindungsgemäß das künstliche neuronale Netz verwendet. Bei der Detektion kann dann beispielsweise ein diskreter Bereich, also eine sogenannte "Bounding-Box", für das erkannte Objekt durch das künstliche neuronale Netz zuerst angelernt werden, und dann in der Anwendung die zumindest ungefähre Position des Objektes mit der Bounding-Box gekennzeichnet werden.

Auf diese Weise kann zum Beispiel auch erkannt werden, ob eine Maske im Bild vorhanden ist, unabhängig davon, an welcher Stelle im Bild sie sich befindet, und es kann beispielsweise erkannt werden, wo sie sich befindet. Wenn zum Beispiel eine Maske von der Ablage abgerutscht ist, und an einer Stelle liegt, die keine vorgesehene Ablageposition ist, kann sie durch das künstliche neuronale Netz erkannt werden, womit eine Kollision des Roboters mit der Maske verhindert werden kann.

Damit ermöglicht es, das erfindungsgemäße Verfahren, für das Bearbeiten der Substrate eine Information dahingehend zu erhalten, ob das Substrat bearbeitet, beispielsweise auch transportiert werden kann, oder nicht, etwa aufgrund einer Fehllage. Die Information kann damit betreffend mögliche Fehllagen beispielsweise auch eine Aussage darüber liefern, ob die Fehllage ein über mehrere Etagen einer Auflage liegendes Substrat betrifft, also etwa ob das Substrat auf den vorgesehenen Auflagepunkten dieser Auflage liegt, und/oder ob die Fehllage mindestens zwei direkt übereinanderliegende Substrate betrifft an einer Auflage betrifft, also ob an den Auflagepunkten oder der Auflage mehr als ein Substrat liegt, insbesondere, wenn nur ein Substrat an dieser Auflage vorgesehen ist.

Ferner kann die Information eine Aussage liefern, ob die Fehllage eine Abweichung von einer vorgegebenen Soll-Lage eines Substrates betrifft, und/oder ob die Fehllage ein nicht auf allen vorgesehenen Auflagepunkten einer Auflage korrekt aufliegendes Substrat betrifft.

Der von dem künstlichen neuronalen Netz erzeugte Informationsdatensatz liefert damit eine Information, welche das Handlingsystem und/oder seine Bewegung beeinflussen und bestimmen kann. Das Substrat kann sich dabei in Kassetten und/oder auf Auflagen und/oder auf einem Endeffektor und/oder auf einem Chuck und/oder auf einer Bearbeitungsstation der Maschine und/oder auf einer Verfahreinheit befinden.

Dabei ist das künstliche neuronale Netz unter anderem dadurch gekennzeichnet, dass die Algorithmen oder Regeln zur Bearbeitung von Kriterien oder Merkmalen zumindest teilweise nicht durch einen Ersteller der Software vorgedacht werden müssen, sondern dass sich das künstliche neuronale Netz auch diese Algorithmen in einem Lernvorgang selber erarbeiten kann.

Da der Lernvorgang selbstständig, und auch mit einer sehr großen möglichen Zahl von Iterationen ablaufen kann, wobei sich bei jeder Iteration das künstliche neuronale Netz mit einer bestimmten Lernrate weiter selbstständig optimiert, können wesentlich komplexere Parameter und Einflussfaktoren berücksichtigt werden, als das mittels manuell erstellter Regeln in Rahmen einer regelbasierenden Bildverarbeitung sinnvoll oder möglich ist.

Zudem können über eine entsprechend große Anzahl von Daten, also Bildern, welche Aufnahmen der realen Objekte und deren Umgebung darstellen und welche zum Lernen verwendet werden, viele Parameter und Einflussfaktoren beim Lernen berücksichtigt werden.

Weiterhin können diese Bilder, die zum Lernen verwendet werden, beispielsweise mit Mitteln der Bildbearbeitung modifiziert werden, indem das beispielsweise das Bildrauschen, und/oder jeweils Kontrast, Helligkeit, Bildschärfe, Skalierung, Aspekt Rate, Rotation, Bildhintergrund, und/oder andere Bildparameter variiert werden, und somit beim Lernen die oder ein Teil solcher Einflussfaktoren zusätzlich mit in den Lernprozess einbezogen werden. Solche Verfahren sind beispielsweise bekannt unter dem Begriff der "Augmentierung".

Im Ergebnis kann dann ein trainiertes künstliches neuronales Netz stehen, welches die Objekte mit den Parametern und Einflussfaktoren zuverlässiger erkennt als eine regelbasierende Bildverarbeitung, und welches mit deutlich weniger Aufwand zu erstellen ist, als die Regeln einer regelbasierenden Bildverarbeitung.

Gemäß einer vorteilhaften Weiterbildung der Erfindung können für die Detektion auch das künstliche neuronale Netz und eine regelbasierende Bildverarbeitung miteinander kombiniert werden. Dies kann wie folgt erfolgen:
Zunächst wird mittels des künstlichen neuronalen Netzes die ungefähre Position des Objektes im Bild bestimmt. Sodann wird aus dieser Position bestimmt, wo sich eine vordefinierte diskrete, also kleinere Region für dieses Objekt befindet, welche zur Vermessung von beispielsweise Abständen mittels regelbasierender Bildverarbeitung geeignet sein kann. Dies stellt dann den Auswertebereich einer regelbasierenden Bildverarbeitung dar.

Vorteilhaft kann diese Kombination insbesondere dann angewendet werden, wenn das Objekt eine stärkere Abweichung von der vordefinierten Position hat, wobei hierzu auch eine Information zur Ausdehnung des Objektes mit umfasst sein kann.

Insbesondere ist es erfindungsgemäß auch möglich, mehrere Objekte im Bild zu finden und insbesondere zu lokalisieren, wobei auch die Abstände mehrere Objekte zueinander bestimmt werden können, beziehungsweise wobei erkannte Objekte als Referenz zu einer Lage- oder Entfernungsbestimmung zu anderen Objekten dienen können. Es kann somit bestimmt werden, welche Objekte sich im Bildbereich der Kamera befinden. Die Objekte können auch Markierungen, Beschriftungen, Aufkleber oder Referenzmarken auf Objekten sein.

Wenn diese Positionen der erkannten Objekte oder Markierungen an die Steuerung des Handlingsystems gegeben werden, kann damit beispielsweise eine Kollision des Handlingsystems mit diesen Objekten verhindert werden. Eine Steuerung des Handlingsystems kann diese erkannten Objekte und deren Positionen auch derart auswerten, dass sich das Handlingsystem selbstständig im Raum orientieren kann, und zumindest teilweise automatisch bzw. autonom trainieren kann.

Beispielsweise kann das Handlingsystem, etwa ein Roboter, mit einer am Roboterarm oder am Endeffektor installierten Aufnahmeeinheit, etwa einer Kamera, auch einen Suchlauf durchführen, um mehrere Objekte zu erkennen oder bestimmte Objekte oder Markierungen bzw. Referenzmarken zu suchen und ihren Standort zu bestimmen. Dieser Suchlauf kann autonom oder teilautonom erfolgen. Beispielsweise kann eine vorgegebene Anzahl an Stationen von dem Roboter angefahren werden und nach entsprechender Bildaufnehme durch die Aufnahmeeinheit können diese Bilder durch das künstliche neuronale Netz analysiert werden, um festzustellen, welche Stationen belegt sind, und/oder ob diese Stationen ordnungsgemäß und fehlerfrei belegt sind. In diesem Zusammenhang können beispielsweise Markierungen an den Stationen vorgesehen sein, welche zusätzliche Informationen über eine ordnungsgemäße Belegung der Station enthalten.

Im Sinne der Erfindung ist es auch vorgesehen, nicht nur die Erkennung des Objektes oder seiner Orientierung autonom durchzuführen, beispielsweise mit der Methode einer Klassifikation, sondern auch die Position des Objektes, insbesondere zumindest eine ungefähre Position, zu detektieren. Bei der Detektion kann dann beispielsweise die Bounding-Box für das erkannte Objekt durch das künstliche neuronale Netz zuerst angelernt werden, und dann in der Anwendung die zumindest ungefähre Position des Objektes mit der Bounding-Box gekennzeichnet werden, welche je nach Abbildungsmaßstab des Bildes auch korrekt skaliert ist.

Damit kann zum Beispiel auch erkannt werden, ob eine Maske im Bild vorhanden ist, unabhängig davon, an welcher Stelle im Bild sie sich befindet, und es kann beispielsweise erkannt werden, wo sie sich befindet. Wenn zum Beispiel eine Maske von der Auflage abgerutscht ist, und an einer Stelle liegt, die keine vorgesehene Ablageposition ist, kann sie durch das künstliche neuronale Netz erkannt werden, womit eine Kollision des Roboters mit der Maske verhindert werden kann.

Über die Erkennung und Lokalisation von Objekten oder Substraten ist es insbesondere auch möglich, das Trainieren einer Anlage zumindest teilweise automatisch ablaufen zu lassen, indem Objekte, Substrate oder Maschinenteile erkannt werden, und/oder lokalisiert werden, und/oder relative Abstände ermittelt werden, und daraus die Steuerbefehle für das Handlingsystem abgeleitet werden.

Es ist weiterhin möglich, die Ergebnisse zu visualisieren, indem in einem Bild gefundene und/oder klassifizierte Objekte, Substrate oder Maschinenteile in dem Bild bezeichnet werden, wobei zum Beispiel der Name des Objektes im Bild eingeblendet wird, und/oder indem in dem Bild die Position dargestellt wird, beispielsweise in Form eines die Position beziehungsweise Umrisse des Objektes zumindest ungefähr darstellenden Rechteckes wie etwa eine Bounding-Box, wobei auch Bildkoordinaten oder absolute Koordinaten in Bezug auf einen Referenzpunkt im System angezeigt werden können.

Es ist weiterhin möglich, die Visualisierung auch an einer schnellen Abfolge von Bildern darzustellen, zum Beispiel anhand eines "Life-Videostreams" der die Bilder erzeugenden mindestens einen Aufnahmeeinheit.

Es ist weiterhin möglich, die Bilder oder Videos drahtgebunden oder wireless auf ein Smartphone, ein Tablet, einen Systemcontroller mit Bildschirm oder eine andere Anzeige zu übertragen. Durch diese Visualisierung kann der das Trainieren des Roboters durchführende Mitarbeiter beim Trainieren stark unterstützt werden

Es ist weiterhin möglich, mittels des künstlichen neuronalen Netzes zu erkennen, ob sich Objekte oder Hindernisse im Bewegungsbereich oder der Bewegungsbahn des Handlingsystems und/oder eines durch das Handlingsystem bewegten Objektes, beispielsweise einer Maske, eines Wafers, oder eines Flat Panel Displays befinden, und/oder um Maßnahmen einzuleiten, eine Kollision des Handlingsystems mit diesen Hindernissen und damit möglicherweise einen Schaden zu verhindern.

Hierzu können Bilder von der vorgesehenen Bewegungsbahn aufgenommen werden, bevor das Handlingsystem diese Bewegungsbahn abfährt, und an das künstliche neuronale Netz übergeben werden. Hierzu können von Vorteil auch Bilder aus unterschiedlichen Positionen verwendet werden, um auch eventuell verdeckte Bereiche zu analysieren. Das künstliche neuronale Netz kann anhand dieser Bilder dann anhand von Vergleichen mit Bildern dieser Bewegungsbahnen im fehlerfreien Zustand analysieren, ob sich Objekte ungeplant in der Bewegungsbahn befinden. In diesen Fällen kann ein Steuerbefehl erzeugt und an das Handlingsystem gegeben werden, welcher einen sofortigen Stopp des Handlingsystems bewirkt. Das erfindungsgemäße Handlingsystem ermöglicht damit auch eine Erkennung von Hindernissen in der Bewegungsbahn des Handlingsystems.

Beispielsweise kann der Bewegungsraum des Handlingsystems dazu permanent oder zeitweise mit mindestens einer Aufnahmeeinheit überwacht werden, und im Fall einer Erkennung eines Hindernisses das Handlingsystem gestoppt werden.

Es kann weiterhin auch ermittelt werden, ob sich etwa andere Objekte in der richtigen Position befinden, die einen fehlerfreien Betrieb ermöglicht, beispielsweise, wenn Substrate durch das Handlingsystem aufgenommen und/oder bewegt werden sollen. So kann beispielsweise geprüft werden, ob eine Tür in der Maschine, welche beispielsweise nur geöffnet sein soll, wenn ein Substrat, beispielsweise ein Wafer, durch diese Tür transportiert werden soll, zum Zeitpunkt des vorgesehenen Transportes tatsächlich offen ist, und das Handlingsystem wird nur dann gestartet, wenn diese Tür tatsächlich offen ist, womit eine Kollision und damit möglicher Weise ein Schaden vermieden werden kann. Solche Verriegelungen werden auch Interlocks genannt.

Weiterhin kann über das künstliche neuronale Netz auch erkannt werden, ob sich ein Mensch oder eine Extremität eines Menschen in diesem Bereich befindet. Auch hier kann der Bewegungsraum des Handlingsystems dazu permanent oder zeitweise mit mindestens einer Aufnahmeeinheit überwacht werden, und im Fall einer Erkennung eines Menschen oder einer Extremität das Handlingsystem gestoppt werden.

Zur Erzeugung des Bildes kann zumindest eine Aufnahmeeinheit vorgesehen sein, welche in das Handlingsystem integriert und/oder an die Maschine oder Anlage der Halbleiterindustrie angebaut sein kann. Sie kann auch im Umfeld angeordnet sein. Die Aufnahmeeinheit kann dabei dauerhaft fest oder auch nur zeitweise fest intergiert oder angebaut sein, etwa zum Trainieren des künstlichen neuronalen Netzes, und kann dann nach Abschluss des Anlernens wieder entfernt werden.

In einer Ausführungsform der Erfindung ist die mindestens eine Aufnahmeeinheit in Bezug auf das Handlingsystem ortsunveränderlich installiert. Dies ermöglicht es, unabhängig von dem Betriebszustand des Handlingsystems immer eine gleiche Perspektive bzw. Blickrichtung während der Aufnahme der Bilder zu erhalten, so dass selbst geringste Änderungen bzw.

Abweichungen von einer Soll-Lage eines Objektes sicher erkannt werden können. Dies kann sich auch anbieten, wenn die Bewegungsbahn des Handlingsystems überwacht werden soll.

Es ist auch möglich, dass sich die mindestens eine Aufnahmeeinheit an beweglichen Elementen des Handlingsystems befindet, beispielsweise an einem Roboterarm oder einem beweglichen Element, etwa an einem Endeffektor eines Roboters, oder an einer Verfahreinheit. Dies ermöglicht es, Bilder während des Betriebs des Handlingsystems aus unterschiedlichen Blickrichtungen aufzunehmen, was von Vorteil sein kann, wenn etwa bei Ansichten aus bestimmten Blickrichtungen Teile des Bildes verdeckt sind, und damit das aufgenommene Bild unvollständig ist.

Daher ist es in einer besonders bevorzugten Ausführungsform der Erfindung vorgesehen, im Fall von unklaren Aussagen oder nicht eindeutigen Zuordnungen durch das künstliche neuronale Netz zumindest ein weiteres Bild zu erzeugen und durch das künstliche neuronale Netz zu erfassen, wobei sich von Vorteil dieses zweite, weitere Bild von dem ersten in zumindest einem Aspekt, beispielsweise der Blickrichtung, unterscheidet.

Im Fall einer teilweisen Verdeckung kann auf diese Weise beispielsweise ein weiteres Bild desselben Ortes aus einem anderen Blickwinkel aufgenommen werden, auf welchen diese Verdeckung nicht auftritt. Diese zweite Aufnahme aus einem anderen Blickwinkel kann dabei in einer bevorzugten Ausführungsform der Erfindung durch das künstliche neuronale Netz selbst veranlasst werden, in dem etwa ein entsprechender Steuerbefehl an die Steuerung der Maschine ausgegeben wird.

Die Aufnahmeeinheit kann dabei einen optischen Sensor, einen Ultraschall-Sensor, einen Abstands-Sensor, einen Reflex-Sensor, ein Radar-Sensor, eine bildgebende Kamera oder Video-Kamera, oder eine Infrarotkamera umfassen.

Die Infrarotkamera ermöglicht es zum Beispiel, in der digitalen Darstellung des Bildes zusätzlich Informationen der Wärmestrahlung der Objekte im Bildfeld zur Verfügung zu stellen. Dies kann nützlich sein, wenn beispielsweise ein Substrat für bestimmte Bearbeitungsprozesse einer genau vorgegebenen Temperatur ausgesetzt sein soll, und das Substrat nur bewegt werden soll, wenn das Substrat selbst oder die Umgebung eine bestimmte Temperatur aufweist.

Der Radar-Sensor ermöglicht es, Abstandswerte von Objekten beziehungsweise von einzelnen Punkten von Objekten zum Sensor in dem durch den Sensor erfassten zweidimensionalen Bereich zu erzeugen, welche zusammengesetzt mit der dritten Abstands-Dimension ein dreidimensionales Profil des erfassten Bereiches darstellen können, welches anstelle des optischen Bildes für das Trainieren, oder auch für das Anwenden des künstlichen neuronalen Netzes verwendet wird.

Es ist in einer bevorzugten Ausführungsform der Erfindung auch vorgesehen, durch das künstliche neuronale Netz mehr als ein Bild zu erfassen, insbesondere zumindest zwei Bilder des gleichen Ortes, welche von unterschiedlichen Aufnahmeeinheiten und/oder unterschiedlich angeordneten Aufnahmeeinheiten erzeugt wurden. Die Informationen dieser Bilder können auf besonders vorteilhafte Weise durch das künstliche neuronale Netz analysiert und miteinander kombiniert werden, um die Zuordnung zu hinterlegten Klassen und damit die Qualität des Informationsdatensatzes erheblich zu verbessern. Insbesondere kann hierdurch die Entscheidungsgrundlage für das künstliche neuronale Netz verbessert werden.

Hierdurch können deutlich genauere Informationen erhalten werden, und das Handlingsystem kann deutlich besser kontrolliert und gesteuert werden.

In einem ersten Aspekt können dabei zumindest zwei Bilder durch das künstliche neuronale Netz erfasst werden, welche sich durch die Position der Aufnahmeeinheit und damit in der Blickrichtung des aufgenommenen Bildes unterscheiden. Hiermit ist es auch möglich, beispielsweise in einer Aufnahme verdeckte Bereiche darzustellen.

Hierzu kann es zum Beispiel vorteilhaft sein, eine erste Aufnahmeeinheit, beispielsweise eine Kamera, ortsfest an dem Handlingsystem zu installieren, welche ein Bild von dem Substrat oder Ort aufnimmt, und eine weitere zweite Aufnahmeeinheit, beispielsweise eine Kamera oder eine Video-Kamera, welche sich an einem beweglichen Element des Handlingsystems befindet, etwa an dem Endeffektor oder der Verfahreinheit. Im Betrieb kann dann ein erstes Bild mit der ersten Kamera erzeugt und dem künstlichen neuronalen Netz zugeführt werden. Wenn die Auswertung durch das KI-Modul dann keine zuverlässige Information zum Beispiel darüber liefern kann, ob das Substrat auf sämtlichen Auflagepunkten einer Auflage vollständig und korrekt aufliegt, kann dann die zweite Kamera oder Video-Kamera während einer weiteren Annäherung des Endeffektors an das Substrat oder den Ort zugeschaltet werden, und weitere Bilder oder VideoSequenzen können erzeugt und dem künstlichen neuronalen Netz zugeführt werden. Sofern dann mehrere Bilder von dem zu untersuchenden Ort vorliegen, ermöglicht dies dem künstlichen neuronalen Netz eine bessere Datenbasis und kann dazu beitragen, die Zuverlässigkeit in der Analyse deutlich zu erhöhen.

Mit diesem Verfahren können besonders günstig die Auswirkungen von Fehllagen minimiert werden, da deutlich genauer erkannt werden kann, ob beispielsweise ein Substrat noch bearbeitet werden kann oder nicht. Dies erhöht die Effizienz des Handlingsystems.

Neben einer im Vergleich zur Erzeugung des ersten Bildes unterschiedlich angeordneten Aufnahmeeinheit zur Erzeugung des zumindest einen weiteren Bildes kann das zweite Bild auch mit einer Aufnahmeeinheit erzeugt werden, welche andere Informationen beiträgt. So kann beispielsweise eine im sichtbaren Wellenlängenbereich arbeitende Kamera mit einer Infrarotkamera oder eine Infrarotkamera mit einem Radar-Sensor kombiniert werden.

In einer weiteren ebenfalls bevorzugten Ausführungsform ist ergänzend oder alternativ vorgesehen, die Zuverlässigkeit der Bestimmung durch das künstliche neuronale Netz und damit die Qualität des Informationsdatensatzes nochmals zu verbessern, wenn etwa durch das künstliche neuronale Netz nicht zweifelsfrei eine Aussage darüber erhalten werden kann, ob die Position eines Substrates, etwa die Auflage des Substrates auf vorgesehenen Auflagepunkten, als Fehllage zu interpretieren ist oder nicht.

So kann zum Beispiel ein leicht schräg aufgelegtes Substrat, welches damit nicht vollkommen fehlerfrei aufliegt, unter bestimmten Umständen dennoch bearbeitet oder prozessiert werden, beispielsweise durch Vorgeben bestimmter Steuerbefehle an die Steuereinheit der Maschine, um auch das leicht schräg aufgelegt Substrat noch greifen zu können.

Erfindungsgemäß ist dazu in einer Ausführungsform vorgesehen, nach Analyse durch das künstliche neuronale Netz in einem weiteren zweiten Schritt mindestens ein durch das künstliche neuronale Netz ermittelte Merkmal mittels eines weiteren Verfahrens der Bilderkennung zu analysieren. Hierzu kann ein klassisches Verfahren zur Bilderkennung, insbesondere ein regelbasiertes Verfahren, verwendet werden. Dies kann beispielsweise ein Verfahren zur Kantenerkennung mittels einer (klassischen) Bildverarbeitung sein. Hierzu kann das ursprünglich erfasste Bild verwendet werden. Es aber ergänzend auch die Information eines zusätzlichen Sensors hinzugezogen werden.

Mit dem hier skizzierten zweistufigen Ansatz kann die Zuverlässigkeit der Information des künstlichen neuronalen Netzes geprüft und/oder durch Verbindung des ersten mit dem zweiten Schritt verbessert werden.

Es ist dem Fachmann ersichtlich, dass die vorstehend genannten Verfahren auch miteinander kombiniert werden können. Dies führt zu einem großen Vorteil der Erfindung, der darin zu sehen ist, dass nicht nur vollständig fehlerfrei abgelegte Substrate prozessiert werden können, sondern auch noch Substrate, welche anhand von entsprechend klassifizierten Bilder durch das künstliche neuronale Netz als noch bearbeitbar angesehen werden.

Vorgesehen ist ferner eine Beleuchtungseinrichtung, welche dazu ausgebildet ist, elektromagnetische Strahlung in Richtung auf das Objekt oder den entsprechenden Ort im Bildfeld der Aufnahmeeinheit zu emittieren. In einer vorteilhaften Ausführungsform der Erfindung ist die Beleuchtungseinrichtung gekoppelt mit der Aufnahmeeinheit, so dass die Beleuchtungseinrichtung vorzugsweise dann zugeschaltet wird und elektromagnetische Strahlung emittiert, wenn mit der Aufnahmeeinheit ein Bild erfasst wird.

Bei Verwendung einer Kamera, welche im sichtbaren Wellenlängenbereich der elektromagnetischen Strahlung sensitiv ist, bietet es sich an, wenn die Beleuchtungseinrichtung ebenfalls elektromagnetische Strahlung zumindest im sichtbaren Wellenlängenbereich, also im Wellenlängenbereich zwischen 380 und 780 nm, emittiert. Von Vorteil ist daher die Beleuchtungseinrichtung derart ausgebildet, dass sie elektromagnetische Strahlung zumindest in demjenigen Wellenlängenbereich emittiert, in welchem die Aufnahmeeinheit sensitiv ist.

In diesem Zusammenhang können auch Bilder erfasst und dem künstlichen neuronalen Netz zugeführt werden, welche bei einer unterschiedlichen Beleuchtung aufgenommen wurden.

Die Beleuchtungseinrichtung kann dabei in das Handlingsystem dauerhaft fest oder zeitweise fest integriert und/oder an dem Handlingsystem oder im Umfeld angebaut sein. Es kann sich anbieten, die Beleuchtungseinrichtung in Bezug auf Handlingsystem ortsunveränderlich zu installieren, um jeweils gleiche Beleuchtungssituationen für das Erfassen eines Bildes zu schaffen.

Es kann sich aber auch als günstig erweisen, die Beleuchtungseinrichtung an beweglichen Elementen des Handlingsystems anzuordnen, bevorzugt an einem Roboterarm oder an einem Endeffektor eines Roboters oder an einer Verfahreinheit. Besonders vorteilhaft kann diese Anordnung sein, wenn auch die Aufnahmeeinheit zusammen mit der Beleuchtungseinheit angeordnet ist, so dass während der Bildaufnahme jeweils aus der gleichen Richtung beleuchtet wird, aus der auch die Bildaufnahme erfolgt. Aufnahmeeinheit und Beleuchtungseinheit können beispielsweise in einer kompakten Bauform gemeinsam in einem Gehäuse vorgesehen sein.

Das künstliche neuronale Netz kann in einer Verarbeitungseinheit als Komponente einer Rechnerarchitektur aufgenommen oder integriert sein, wobei die Rechnerarchitektur ferner eine Rechner-Hardware und ein Betriebssystem des Rechners als weitere wesentliche Komponenten neben anderen Komponenten oder Bauteilen umfassen kann.

Von Vorteil ist die Rechnerarchitektur derart ausgebildet, dass das Erzeugen des Informationsdatensatzes durch das künstliche neuronale Netz nahezu in Echtzeit oder sogar in Echtzeit erfolgt nach DIN ISO/IEC 2382. Hiermit ist die Zeitspanne zwischen Aufnahme des Bildes und Ausgabe des Informationsdatensatzes durch das künstliche neuronale Netz zu verstehen. Es ist auch denkbar, die Bilder aufzuzeichnen, und den Informationsdatensatz mit zeitlichem Versatz zu erzeugen, wenn das in der konkreten Anwendung möglich ist.

Die Rechnerarchitektur kann zentral oder dezentral organisiert sein. Dies bedeutet, dass zumindest die drei vorstehend genannten Komponenten Verarbeitungseinheit, Rechner-Hardware und Betriebssystem an einer Stelle zusammengefasst sein können, oder einzeln verteilt an verschiedenen Stellen oder auch an verschiedenen Standorten angeordnet sein können. Die Kommunikation zwischen den einzelnen Komponenten kann dabei drahtgebunden oder auch drahtlos über geeignete Funk-Verfahren, zum Beispiel W-LAN oder Bluetooth, erfolgen.

So können gemäß einer zentral organisierten Ausführungsform der Erfindung diese Komponenten in einem System-Controller der Maschine der Halbleiterindustrie integriert sein, beispielsweise in einen Roboter oder in einen Endeffektor eines Roboters, oder in einem Roboter-Controller. Die Rechnerarchitektur kann auch in einer der Maschine übergeordneten Steuerung integriert sein.

In einer bevorzugten Ausführungsform kann diese Rechnerarchitektur in einer dem Handlingsystem nicht zugeordneten Steuerung integriert sein, beispielsweise in einer Cloud oder in einem anderen Rechner an einem beliebigen weltweiten Standort. Dies ermöglicht es beispielsweise, an einer zentralen Stelle sämtliche für das künstliche neuronale Netz erforderlichen Daten zu bündeln und zentral zur Verfügung zu stellen.

Gemäß einer dezentral organisierten Ausführungsform der Rechnerarchitektur können einzelne der oben genannten Komponenten, also Verarbeitungseinheit, Rechner-Hardware oder Betriebssystem, an verschiedenen Stellen angeordnet sein. Diese können die vorstehend genannten Stellen sein, also beispielsweise der System-Controller des Handlingsystems oder der Endeffektor.

So kann es günstig sein, die Verarbeitungseinheit und/oder die das Betriebssystem über mehr als einen dieser Stellen wie vorstehend bezeichnet verteilt ablaufen zu lassen. Dies bietet sich an, wenn etwa sehr große Datenbestände mit Bildern vorhanden sind oder erzeugt wurden, welche zentral gespeichert und verwaltet werden sollen. Die Verarbeitungseinheit mit den Datenbeständen kann dann beispielsweise in einer zentralen Cloud vorgehalten werden, und die Rechner-Hardware und/oder das Betriebssystem kann dezentral an oder in dem Handlingsystem vorgehalten werden. Es ist für den Fachmann ersichtlich, dass auch andere Kombinationen möglich und günstig sein können.

So kann etwa auch das Trainieren des künstlichen neuronalen Netzes auf einer anderen, weiteren Rechnerarchitektur durchgeführt wird als die Anwendung des künstlichen neuronalen Netzes.

In einem weiteren Aspekt betrifft die Erfindung ein Verfahren zum Bereitstellen eines angelernten oder trainierten künstlichen neuronalen Netzes zur Verwendung in einem Verfahren zur Kontrolle oder Steuerung von Handlingsystemen, wobei ein künstliches neuronales Netz verwendet wird.

Das Verfahren zum Bereitstellen eines angelernten oder trainierten künstlichen neuronalen Netzes kann dabei die nachfolgenden Schritte umfassen:
- Bereitstellen einer Verarbeitungseinheit, welche zumindest ein künstliches neuronales Netz, aufweist oder umfasst,
- Trainieren des künstlichen neuronalen Netzes durch Erfassen und Bereitstellen von zumindest einem Bild, bevorzugt, einer Vielzahl von wenigstens 20 Bildern, wenigstens 100, besonders bevorzugt wenigstens 1.000 Bildern.

Es kann bereits mit einem oder wenigen Bildern möglich sein, das künstliche neuronale Netz zu trainieren. So kann beispielsweise ein Bild ein fehlerfrei auf einem Slot abgelegtes Substrat zeigen, welches dann für die weitere Analyse durch das künstliche neuronale Netz herangezogen wird. Nachteilig kann es dabei sein, dass nur solche Bilder von Substraten dann als fehlerfrei erkannt und entsprechend bewertet werden können, wenn sie diesem einen Bild entsprechen. Bereits leichte Abweichungen von dieser Position könnten dann durch das künstliche neuronale Netz nicht mehr optimal erkannt werden.

Von daher wird es sich in den allermeisten Fällen anbieten, mehrere Bilder, bevorzugt eine Vielzahl von Bildern, bevorzugt wenigstens 20 Bildern, wenigstens 100, besonders bevorzugt wenigstens 1.000 Bildern oder noch mehr dem künstlichen neuronalen Netz zur Verfügung zu stellen.

Wie weiter oben ausgeführt, kann das digitalisierte Bild dabei vollständig das erfasste analoge Bild umfassen, oder auch nur einen Bildausschnitt oder auch mehrere Bildausschnitte. Dies kann sich beispielsweise anbieten, wenn die ordnungsgemäße Belegung einer Kassette für Wafer geprüft werden soll. Eine derartige Kassette kann beispielsweise 25 einzelne Ablageorte für Wafer umfassen, wobei dann aus einem analogen Gesamtbild jeweils Einzelbilder bzw. Slot-Bilder für jeden Ablageort generiert werden, im Beispiel also 25 Einzelbilder.

Ein Bildausschnitt bzw. ein Einzelbild kann demnach eine Auflage darstellen. Die Verarbeitungseinheit kann hierzu von Vorteil entsprechende Module oder Einrichtungen für eine Bildverarbeitung umfassen.

In einer bevorzugten Ausführungsform umfasst das Verfahren zum Bereitstellen eines angelernten oder trainierten künstlichen neuronalen Netzes das Erfassen und/oder Bereitstellen einer Vielzahl von Bildern für das Trainieren, welche sich in der Ausprägung zumindest eines Parameters oder Einflussfaktors unterscheiden. Diese Parameter können sich auf das Objekt selbst oder auf die Umgebung des Ortes, welcher aufgenommen werden soll, beziehen.

Demnach unterscheiden sich Bilder vorzugsweise in der Ausprägung zumindest eines Parameters voneinander. Hierzu können gehören:
- die Präsenz des Objektes an einem Ort, also das Vorhandensein oder das Fehlen eines Objektes an einem Ort, beispielsweise eines Substrates im Slot einer Kassette oder auf einer Auflage, und an welchem ein Substrat vorhanden sein sollte. Selbstverständlich können diese Bilder auch Orte umfassen, an denen bei fehlerfreiem Betrieb der Maschine kein Substrat vorhanden sein sollte,
- die Position der Objekte, beispielsweise eines Substrates, Wafers, Maske, Flat Panel Display, Auflage, Kassette,
- Markierung, Maschinenteil, oder Teil der vorgenannten
- die Lage des Substrates in Bezug auf eine Soll-Lage, also beispielsweise das korrekte Aufliegen des Substrates auf den hierfür vorgesehenen Auflagepunkten,
- die Orientierung des Objektes in Bezug auf eine Referenz in der Maschine
- die Anzahl der Objekte an einem Ort, also beispielsweise die Anzahl der Substrate in einem Slot einer Kassette oder in der Kassette insgesamt,
- die Farbe und/oder das Transmissionsverhalten des Objektes,
- die Abmessungen des Objektes,
- die Beschaffenheit der Kanten des Objektes,
- das Vorhandensein von Erkennungsmarken, also beispielsweise das Vorhandensein von sogenannten "Wafer-Notches" auf oder an dem Substrat,
- die Beschaffenheit der Oberfläche des Objektes, also beispielsweise eine glatte, rauhe oder beschichtet Oberfläche,
- das Vorhandensein eines Pellicle sowie Ort, Lage und Orientierung des Pellicle bei Masken.

Weitere Parameter können die Umgebung betreffen:
- die Beleuchtungsverhältnisse, also etwa die Lichtstärke und/oder Lichtrichtung,
- die Art, die Farbe und/oder die Beschaffenheit des Hintergrundes,
- die Bildschärfe,
- die Fokussierung,
- die Reflektion anderer Objekte auf das Substrat
- Lichteinstreuung aus der Umgebung,
- Streuung der Eigenschaften verschiedener Aufnahmeeinheiten, wie Kameras, Belechtung, Abbildungsoptik.

Die vorstehend genannte Auflistung von Parametern und Einflussgrößen sowie ihre möglichen Ausprägungen ist nicht als abschließend zu betrachten. Sie stellt vielmehr eine Auswahl geeigneter Parameter und Ausprägungen dieser Parameter dar.

In einer Weiterbildung der Erfindung können die Unterschiede in zumindest einem Teil dieser Bilder auch künstlich erzeugt werden können, beispielsweise durch sogenannte "Augmentierung" wie oben erläutert. Die hierzu verwendeten Bilder können von der Aufnahmeeinheit stammen, oder es können auch andere Bilder verwendet werden, beispielsweise aus einer Datenbank.

Das künstliche neuronale Netz kann anhand einer Kategorisierung oder Klassifikation der Bilder trainiert werden.

Ziel für das Trainieren des künstlichen neuronalen Netzes ist es typischerweise, eine möglichst große Bandbreite an unterschiedlichen Ausprägungen der Parameter zu erfassen und zu Klassifizieren.

In einer bevorzugten Ausführungsform ist vorgesehen, dass auch während der Anwendung des künstlichen neuronalen Netzes, also während des Verfahrens zur Bearbeitung von Substraten mit der Maschine der Halbleiterindustrie, in der Maschine Bilder erfasst und gespeichert werden, um diese in mindestens einem initialen oder mindestens einem neuen Lernprozess zum weiteren Trainieren und damit zur stetigen Verbesserung des Ergebnisses des künstlichen neuronalen Netzes zu verwenden.

Hierdurch ist es beispielsweise möglich, auch Schwankungen in der Ausprägung von Parametern, welche sich über längere Zeiträume ergeben können, zu erfassen und dem künstlichen neuronalen Netz zur Verfügung zu stellen. So kann es zum Beispiel vorkommen, dass sich die Lichtverhältnisse durch natürliches Licht an einem Aufnahmeort für Substrate im Jahresverlauf ändern. Durch die kontinuierliche Nachführung können derartige Schwankungen oder "schleichende" Veränderungen kompensiert werden.

Auch bei künstlicher Beleuchtung kann es zu solchen "schleichenden" Veränderungen während des Betriebes der Maschine der Halbleiterindustrie kommen, was bei regelbasierenden Bildverarbeitungssystem zu Problemen führen kann. So unterliegen zum Beispiel auch moderne LED Leuchten und Leuchtmittel Alterserscheinungen, beispielsweise Alterung, Degradation, Helligkeitsverlust und/oder Lichtstromrückgang. Der Lichtstrom kann also sich über die Zeit verändern, insbesondere sinken. Dies kann auch unterschiedlich schnell erfolgen, der Rückgang verhält sich dabei nicht linear. Der Lichtstrom sinkt anfangs nur sehr langsam und fällt mit der Zeit immer schneller ab.
Gründe hierfür können in minimalen Verunreinigungen im Halbleiterkristall des LED-Chips liegen, welche zu Materialveränderungen über die Zeit führen können.

Auch hier kommen die Vorteile des erfindungsgemäßen Verfahrens zum Tragen. So kann das künstliche neuronale Netz in einen quasi-kontinuierlichen Zustand "nachgelernt" werden, in dem zu bestimmten Zeitabständen, beispielweise einmal täglich, wöchentlich oder monatlich, Bilder durch das künstliche neuronale Netz aktuelle Bilder erfasst werden. Diese Bilder können mit bereits vorhandenen und gespeicherten Bildern verglichen werden, so dass das künstliche neuronale Netz in Bezug auf die Veränderungen in Bezug auf die Produktionsumgebung und/oder die Substrate kontinuierlich oder quasi-kontinuierlich trainiert werden kann. Durch das künstliche neuronale Netz können damit auch sehr geringe Veränderungen in der Produktionsumgebung, aber auch in Bezug auf die Substrate, etwa infolge geometrischer Änderungen, kompensiert werden. Dies ist bei regelbasierenden Systemen nicht möglich. Auch eine Augmentierung erscheint hier schwierig, da beispielsweise Alterungsprozesse von Leuchten simuliert werden müssten.

Mit von der Erfindung umfasst ist ferner ein Handlingsystem, ein System oder eine Maschine zur Bearbeitung von Substraten in der Halbleiterindustrie, ausgebildet zur Ausführung eines Verfahrens wie vorstehend beschrieben.

Das Handlingsystem kann einen Roboter, ein bewegliches Element, bevorzugt ein Roboterarm und/oder ein Endeffektor, oder eine Verfahreinheit,
eine Verarbeitungseinheit, welche zumindest ein trainiertes künstliches neuronales umfasst, und eine Aufnahmeeinheit zum Erfassen zumindest eines Bildes, umfassen.

Mit von der Erfindung umfasst ist ferner ein Computerprogrammprodukt, welches direkt in einem Speicher einer Verarbeitungseinheit des Systems wie vorstehend beschrieben ladbar ist, mit Programmcode-Mitteln, um ein Verfahren zur Kontrolle oder Steuerung von Handlingsystemen auszuführen, wenn das Computerprogrammprodukt in der Verarbeitungseinheit ausgeführt wird.

Durch das erfindungsgemäße Verfahren zur Kontrolle oder Steuerung von Handlingsystemen, ergeben sich neben den bereits beschriebenen eine Vielzahl von weiteren Vorteilen. So können diese Handlingsysteme auch bei hoher Komplexität hinreichend zuverlässig arbeiten, und das Handlingsystem kann flexibel auf Schwankungen reagieren.

Ein großer Vorteil liegt weiterhin darin, dass die Algorithmen zur Bearbeitung von Kriterien zumindest nicht vollständig durch einen Anlagenbediener oder Programmierer vorgedacht werden müssen, bzw. starre Regeln erstellt werden müssen, sondern dass sich das künstliche neuronale Netz diese Algorithmen in einem Lernvorgang, dem Trainieren, selber erarbeitet.

Da dieser Lernvorgang selbstständig ablaufen kann, und dabei auch mit einer sehr großen möglichen Zahl von Iterationen, wobei sich bei jeder Iteration das Netzwerk mit einer bestimmten Lern-Rate weiter selbstständig optimiert, können wesentlich komplexere Parameter oder Einflussfaktoren vorgesehen werden, als es mittels manuell erstellter Regeln wirtschaftlich sinnvoll darstellbar ist.

Zudem können über eine entsprechend große Anzahl und geeignete Auswahl der Bilder, welche Aufnahmen der realen Objekte und deren Umgebung darstellen und welche zum Trainieren verwendet werden, sehr viele verschiedene Parameter berücksichtigt werden.

Zudem können diese Bilder, die zum Lernen verwendet werden, beispielsweise weiter mit Mitteln der Bildbearbeitung modifiziert werden, indem etwa das Bildrauschen, und/oder jeweils Kontrast, Helligkeit, Bildschärfe, Skalierung, Aspekt Rate, Rotation, Bildhintergrund, und/oder andere Bildparameter variiert werden, und somit beim Trainieren oder Anlernen die verschiedenen Parameter oder zumindest ein Teil davon bereits mit in den Lernprozess einbezogen werden. Solche Verfahren sind beispielsweise bekannt unter dem Begriff "Augmentierung".

Im Ergebnis wird durch die Erfindung auf diese Weise ein trainiertes künstliches neuronales Netz zur Verfügung gestellt, welches eine zuverlässigere Kontrolle oder Steuerung von Handlingsystemen ermöglicht als eine regelbasierende Bildverarbeitung. Zudem kann dies mit geringerem Aufwand erreicht werden als bei einer regelbasierenden Bildverarbeitung.

Weiterhin ist das künstliche neuronale Netz weniger beschränkt auf die Auswertung diskreter Regionen wie die regelbasierende Bildverarbeitung, wenn ein Bild ausgewertet wird.

Dadurch können in die Auswertung durch das künstliche neuronale Netz auch vollständige analoge Bilder einbezogen werden, in denen ein Objekt erkannt werden kann, auch wenn sich das Objekt in abweichender Position in Bezug auf die gelernten Bilder befindet. Dies stellt einen großen Vorteil gegenüber einer regelbasierenden Bildverarbeitung dar, in der typischerweise eine diskrete Region für die Erkennung eines Objektes definiert ist. Sofern sich das Objekt dann durch eine Positionsabweichung außerhalb dieser Region befindet, kann es nicht erkannt werden.

Weiterhin ist es möglich, nicht nur die Erkennung des Objektes, also die Präsenz des Objektes, oder seine Orientierung zu erkennen, sondern auch seine Position, insbesondere seine ungefähre Position (Detektion). Bei der Detektion kann dann beispielsweise eine sogenannte "Bounding-Box" für das erkannte Objekt durch das künstliche neuronale Netz zuerst angelernt werden, und dann in der Anwendung die zumindest ungefähre Position des Objektes mit der "Bounding-Box" gekennzeichnet werden, wobei dann die Bounding-Box entsprechend dem Abbildungsmaßstab des Objektes im jeweiligen Bild in der Anwendung korrekt skaliert sein kann.

Die Erfindung ermöglicht eine Erkennung eines Substrates, beispielsweise einer Maske, eines Wafers oder Flat Panel Displays, sowie auch die Bestimmung der Position oder der Größe des Subjektes bei verschiedenen Beleuchtungsverhältnissen, bei unterschiedlichen Farben des Substrates oder des Hintergrundes, oder auch bei unterschiedlichen Bildschärfe, beispielsweise infolge von auftretenden Vibrationen während der Bildaufnahme, bei Lichteinstreuungen aus der Umgebung oder bei kleineren, in einem Toleranzbereich liegenden Abweichungen der Position oder der Lage des Substrates.

Dabei kann das Bild der Aufnahmeeinheit auch auf ein Display, bevorzugt drahtlos, insbesondere auf ein Display eines tragbaren elektronischen Geräts, übertragen werden. Dies kann genutzt werden, um das Ergebnis der Anwendung des künstlichen neuronalen Netzes, also eine Information über die Klassifikation und/oder eine Information, welche die Klassifikation ermöglicht, auf dem Display auszugegeben.

Dabei kann auch die Position eines Objektes, insbesondere eines Substrates, einer Maske, eines Wafers oder eines Flat Panels Displays auf dem Display mit angezeigt werden, beispielsweise mittels einer farblichen Umrandung der Maske, des Wafers, oder des Flat Panel Displays, oder eines Teiles derselben, und/oder durch Angabe von Positionsdaten, als Pixelkoordinaten, oder umgerechnet in Positionen in Bezug auf bekannte Referenzpositionen des Handlingsystems.

Die Information für die visuelle Darstellung der Maschine, Substrate, Objekte oder Maschinenteile kann auch in einer erweiterten Realität ("Augmented Reality") dargestellt werden, indem beispielsweise eine Person auf einem Bildschirm oder in einer aufsetzbaren Brille oder über eine andere visuelle Darstellung die Informationen eingeblendet bekommt, zum Beispiel, aber nicht begrenzt auf, die Klassifikation von Objekten, Substraten oder Maschinenteilen.
Die Erfindung wird nachfolgend anhand bevorzugter Ausführungsformen und unter Bezugnahme auf die beigefügten Figuren detaillierter beschrieben.

### Die Zeichnungen zeigen:

- Fig. 1: schematisch ein Ausführungsbeispiel mit einer geöffneten Kassette für die Aufnahme von Wafern mit korrekt angeordneten Wafern und einer Aufnahmeeinheit,
- Fig. 2: schematisch ein Bild der geöffneten Kassette aus Fig. 1,
- Fig. 3: schematisch den Ablauf des Trainierens und Anlernens des künstlichen neuronalen Netzwerkes an einem Ausführungsbeispiel einer mit Wafern bestückten Kassette,
- Fig. 4: schematisch den Aufbau eines "CNN"-Netzwerkes der Kassettenbelegung in einer stark vereinfachten Darstellung,
- Fig. 5a: schematisch die Anwendung des trainierten künstlichen neuronalen Netzes zur Erkennung einer Kassettenbelegung,
- Fig. 5b: schematisch einen Ausschnitt einer Klassifikationstabelle anhand eines Ausführungsbeispiels,
- Fig. 6: schematisch ein Ausführungsbeispiel eines weiteren Aufbaus mit einer Aufnahmeeinheit und einer Beleuchtungseinheit,
- Fig. 7: schematisch ein Ausführungsbeispiel für eine geeignete Software-Architektur,
- Fig. 8: schematisch ein Ausführungsbeispiel für eine Rechnerarchitektur,
- Fig. 9: schematisch ein Ausführungsbeispiel einer geöffneten Kassette mit Wafern in korrekter Lage und in Fehllage,
- Fig. 10: schematisch ein Ausführungsbeispiel einer Aufnahme für Wafer mit einem aufgelegten Wafer in korrekter Lage,
- Fig. 11a, 11b: schematisch ein Ausführungsbeispiel einer Aufnahme für Wafer mit einem aufgelegten Wafer in korrekter Lage (Fig. 11a) und in Fehllage (Fig. 11b),
- Fig. 12a, 12b: schematisch ein weiteres Ausführungsbeispiel einer Aufnahme für Wafer mit einem aufgelegten Wafer in korrekter Lage (Fig. 12a) und in Fehllage (Fig. 12b),
- Figs. 13a-13f: schematisch ein weiteres Ausführungsbeispiel einer Aufnahme für Wafer mit unterschiedlichen Ausbildungen des Pellicle,
- Figs. 14a-14f: schematisch ein Ausführungsbeispiel für eine Bilderkennung auf Basis für Wafer mit unterschiedlichen Ausbildungen des Pellicle,
- Figs, 15a, 15b: schematisch ein weiteres Ausführungsbeispiel mit unterschiedlicher Anordnung der Aufnahmeeinheit,
- Fig. 16: schematische eine Ansicht eines Handlingsystems zur Prozessierung von Halbeiterbauelementen,
- Fig. 17: ein Ausführungsbeispiel mit einem einzigen Kameragehäuse mit zwei Kameras,
- Fig. 18: ein Ausführungsbeispiel, bei welchem eine Kamera mit integrierter Beleuchtung in einem Endeffektor integriert ist,
- Fig. 19: eine weitere Ausführungsform der Erfindung, bei welcher die Kameras an den Armen des Endeffektors angeordnet sind,
- Fig. 20: eine Seitenansicht und eine Draufsicht von oben auf wesentliche Bestandteile einer Maschine der Halbleiterindustrie zur Prozessierung von Halbleiterbauelementen,
- Fig. 21: die in Fig. 20 dargestellte Anlage im Ruhezustand in einer Draufsicht,
- Fig. 22: die in Fig. 20 dargestellte Anlage im Betriebszustand in einer Draufsicht,
- Fig. 23: die in Fig. 20 dargestellte Anlage in einem weiteren Betriebszustand in einer Draufsicht,
- Fig. 24: ein Ausführungsbeispiel zum Anlernen eines Roboters,
- Fig. 25: ein weiteres Ausführungsbeispiel zum Anlernen eines Roboters,
- Fig. 26: ein weiteres Ausführungsbeispiel zum Anlernen eines Roboters, wobei der Roboter in stärkerer Abweichung von einer vordefinierten Position steht,
- Fig. 27: die Vorteile des erfindungsgemäßen Verfahrens am Beispiel des Ausführungsbeispiels aus Fig. 26,
- Fig. 28: ein weiteres Ausführungsbeispiel zum Anlernen eines Roboters, wobei mehrere Objekte im Bild erkannt werden können,
- Fig. 29: ein weiteres Ausführungsbeispiel zum Anlernen eines Roboters, wobei der Roboter einen Suchlauf durchführt, und
- Fig. 30: ein weiteres Ausführungsbeispiel zum Anlernen eines Roboters mit ortsfest angeordneten Aufnahmeeinheiten.

### Detaillierte Beschreibung bevorzugter Ausführungsformen

Bei der nachfolgenden detaillierten Beschreibung bevorzugter Ausführungsformen bezeichnen um der Klarheit willen gleiche Bezugszeichen im Wesentlichen gleiche Teile in oder an diesen Ausführungsformen. Zur besseren Verdeutlichung der Erfindung sind die in den Figuren dargestellten bevorzugten Ausführungsformen jedoch nicht immer maßstabsgerecht gezeichnet.

Die Erfindung betrifft allgemein ein Handlingsystem, wobei das Handlingsystem einen Roboter oder ein bewegliches Element, bevorzugt einen Roboterarm und/oder einen Endeffektor, umfasst und/oder eine Verfahreinheit, und wobei das Handlingsystem vorzugsweise ferner Mittel zum Greifen, Transportieren und/oder Ablegen eines Substrates aufweist. Das Handlingsystem kann dabei das Transportieren eines Substrates zwischen zwei oder mehreren Stationen betreffen, beispielsweise einem Ablageort oder einer Bearbeitungsstation, oder auch das Prozessieren eines Substrates.

Erfindungsgemäß wird mindestens ein Bild, welches einen Ort in oder an dem Handlingsystem oder in der Umgebung des Handlingsystems darstellt, in digitalisierter Form von einem künstlichen neuronalen Netz erfasst,
und durch das künstliche neuronale Netz wird das Bild analysiert und ein Informationsdatensatz und/oder ein Steuerbefehl erzeugt, mit welchem
das Handlingsystem direkt oder unterstützend gesteuert, ausgerichtet, trainiert, und/oder kontrolliert wird.
Das Bild kann auch aus einer Datenbank dem künstlichen neuronalen Netz zugeführt werden.

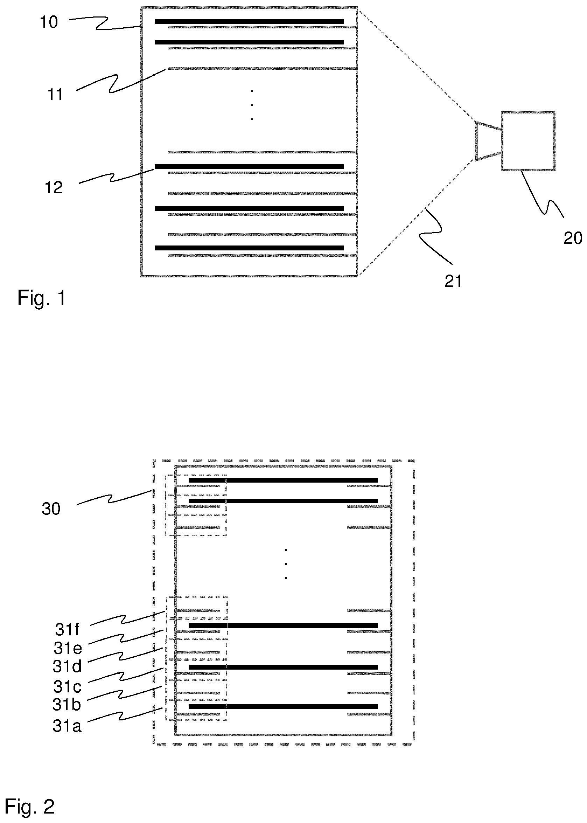

Fig. 1 zeigt schematisch ein Ausführungsbeispiel mit einem Speicher 10 in Form einer geöffneten Kassette für die Aufnahme von Substraten 12, im Ausführungsbeispiel zur Aufnahme von Wafern, in einer Draufsicht.

In dem Ausführungsbeispiel ist nur ein Ausschnitt des Speichers 10 dargestellt, welcher über insgesamt 25 einzelne Ablageorte 11 bzw. Slots für die Aufnahme jeweils eines einzelnen Substrats 12 verfügt.

In dem Ausführungsbeispiel sind der Übersichtlichkeit halber lediglich 9 derartige Ablageorte 11 eingezeichnet. Von den Ablageorten 11 sind in dem Beispiel fünf Ablageorte 11 mit Substraten 12 belegt und vier Ablageorte 11 sind nicht belegt. In dem Ausführungsbeispiel sind sämtliche Ablageorte 11, welche belegt sind, korrekt belegt. In anderen Worten, sämtliche Wafer 12 sind korrekt und fehlerfrei abgelegt.

Die Rechnerarchitektur und die Maschine der Halbleiterindustrie ist in diesem Ausführungsbeispiel nicht dargestellt.

Die gestrichelte Linie 21 markiert den Aufnahmebereich bzw. Bildbereich der Aufnahmeeinheit 20. In dem Beispiel handelt es sich bei der Aufnahmeeinheit 20 um eine Kamera.

Die Aufnahmeeinheit 20 erfasst den abgebildeten Bildbereich, im Beispiel also die gesamte, geöffnete Kassette, und erzeugt eine digitale Darstellung, welche dem künstlichen neuronalen Netz zur Verfügung gestellt wird.

Die Aufnahmeeinheit 20 kann dabei neben der gezeigten bildgebenden Kamera einen optischen Sensor, einen Ultraschall-Sensor, einen Abstands-Sensor, einen Reflex-Sensor, ein Radar-Sensor, eine Video-Kamera, oder eine Infrarotkamera umfassen.

Das erzeugte Bild wird einem künstlichen neuronalen Netz zugeführt, um eine Information über die Präsenz oder Position oder Orientierung eines Objektes im Bild,
oder über die Art des Objektes im Bild, insbesondere das Vorhandensein von Auflagen, Kassetten, oder von Teilen, oder von Markierungen, Aufklebern, Beschriftungen oder Referenzmarken,
oder über mögliche Hindernisse im Bewegungsbereich des Handlingsystems wie Türen oder Loadlocks,
oder über das Vorhandensein von Bearbeitungsstationen
oder über den Abstand zwischen zumindest einem Objekt im Bild zu einem Bezugspunkt des Handlingsystems,
oder über die Position des Objektes im Bild,
oder über die Abmessung des Objektes im Bild zu erhalten.

Der Informationsdatensatz und/oder der Steuerbefehl kann von der Steuerung des Handlingsystems verwendet werden,
oder an ein übergeordnetes Steuerungssystem weitergegeben werden,
oder an einen Bediener weitergegeben werden, der aus dieser Information Rückschlüsse für sein Handeln zur Bedienung des Handlingsystems zieht, oder diese Information an Steuerungen oder andere Bediener weitergibt,
oder an eine Anzeigevorrichtung weitergegeben werden,
oder für spätere oder weitere Auswertungen gespeichert werden.

Der Informationsdatensatz umfasst demnach eine Information, über die ermittelte Präsenz oder Position oder Orientierung eines Objektes im Bild,
oder über die Art des Objektes im Bild, insbesondere das Vorhandensein von Auflagen, Kassetten, oder von Teilen, oder von Markierungen, Aufklebern, Beschriftungen oder Referenzmarken,
oder über mögliche Hindernisse im Bewegungsbereich des Handlingsystems wie Türen oder "Loadlocks",
oder über das Vorhandensein von Bearbeitungsstationen
oder über den Abstand zwischen zumindest einem Objekt im Bild zu einem Bezugspunkt des Handlingsystems,
oder über die Position des Objektes im Bild,
oder über die Abmessung des Objektes im Bild.

Es ermöglicht damit, beispielsweise Fehllagen des Substrates 12 zu erkennen, umfassend ob die Fehllage ein über mehrere Etagen einer Auflage liegendes Substrat 12 betrifft, und/oder ob die Fehllage mindestens zwei direkt übereinander liegende Substrate 12 betrifft, und/oder ob die Fehllage eine Abweichung von einer vorgegebenen Soll-Lage eines Substrates 12 betrifft, und/oder
ob die Fehllage ein nicht auf allen vorgesehenen Auflagepunkten einer Auflage korrekt aufliegendes Substrat 12 betrifft.

Das Substrat 12 kann dabei beispielsweise in Kassetten, wie im Ausführungsbeispiel gezeigt, und/oder auf Auflagen und/oder auf einem Endeffektor und/oder auf einem Chuck und/oder auf einer Bearbeitungsstation der Maschine und/oder auf einer Verfahreinheit befinden.

Es ermöglicht damit auch, das Vorhandensein von Auflagen, Kassetten, oder von Teilen hiervon durch die Klassifikation des Objektes, also die Bestimmung der Art eines aufgefundenen Objektes, oder das Vorhandensein von Markierungen, wie beispielsweise Aufklebern, Beschriftungen oder Referenzmarken zu ermitteln.

Es ermöglicht ferner, das Vorhandensein von Teilen der Maschine, beispielsweise die Auflagen eines Endeffektors, oder von möglichen Hindernissen im Bewegungsbereich des Handlingsystems wie Türen, "Loadlocks" oder ähnliches, aber auch das Vorhandensein von Bearbeitungsstationen der Maschine zu ermitteln.

Es ermöglicht weiterhin die Bestimmung der Position von Substraten beziehungsweise der vorhandenen Objekte zu bestimmen

Durch das künstliche neuronale Netz kann auch mehr als ein Bild erfasst werden, insbesondere zumindest zwei Bilder, vorzugsweise des gleichen Ortes, welche aber von unterschiedlichen Aufnahmeeinheiten und/oder unterschiedlich angeordneten Aufnahmeeinheiten erzeugt werden. Fig. 2 zeigt schematisch ein Bild bzw. ein Gesamtbild 30 der geöffneten Kassette aus Fig. 1 in einer Draufsicht.

Das Bild 30 ist in dem Beispiel in einzelne Bilder unterteilt, welche jeweils einen Ablageort 11 bzw. einen Slot zeigen. In dem abgebildeten Beispiel sind der Übersichtlichkeit halber die untersten sechs Slot-Bilder 31a, 31b, 31c, 31d, 31e und 31f gekennzeichnet.

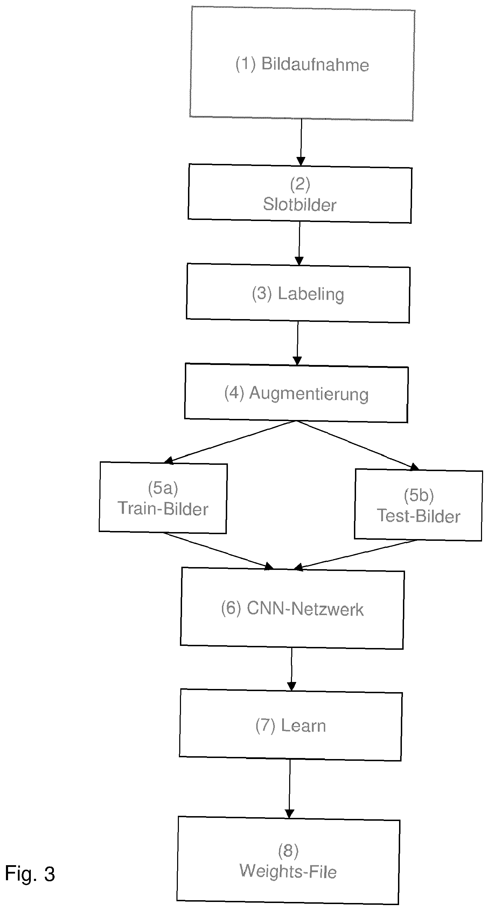

Fig. 3 zeigt schematisch den Ablauf des Trainierens des künstlichen neuronalen Netzwerkes an einem Ausführungsbeispiel einer mit Substraten 12, im Beispiel
mit Wafern 12 bestückten Kassette. Die einzelnen Schritte sind mit (1) bis (8) gekennzeichnet und sollen nachstehend dargestellt werden.

In einem ersten Schritt (1) erfolgt eine Bildaufnahme von einem oder mehreren Bildern der geöffneten Kassette mit 25 Ablageorten für Wafer und bei verschiedenen Slot-Belegungen. Hierzu können auch Bilder aus verschiedenen Blickwinkeln aufgenommen werden.

In einem zweiten Schritt (2) werden hieraus die im Beispiel 25 einzelnen Slot-Bilder erzeugt. Dies kann manuell durch Bildausschnitte aus dem Gesamtbild 30 erfolgen; es ist aber beispielsweise auch möglich, Bildbereiche des Gesamtbildes 30 durch die "Bounding-Boxen" zu erzeugen, welche dann durch das künstliche neuronale Netz verarbeitet werden können. Die Bildausschnitte können leicht zu verschiedenen Größen variiert werden; die optimale Größe hängt unter anderem von der Auslegung des künstlichen neuronalen Netzes ab.

In einem dritten Schritt (3) erfolgt ein sogenanntes "Labeling", d.h. eine Zuweisung zu Klassen: belegter Slot oder freier Slot. Diese Klassifizierung kann manuell erfolgen. Beispielsweise können die Bilder in verschiedenen Ordnern abgelegt werden, welche den Klassen zugeordnet sind; es ist aber beispielsweise auch möglich, die Labels wie auch "Bounding-Boxen" in jeweils den Einzelbildern zugeordneten separaten Dateien zuzuweisen. Wenn die Position des Wafers - oder des Teils des Wafers - durch das Netzwerk auch bestimmt werden soll, erfolgt in diesem Schritt auch die Definition der Bounding-Box für die Erkennung der Position des Wafers.

In einem vierten Schritt (4) erfolgt die Erzeugung von verschiedenen Ausprägungen der Parameter durch Augmentierung der Slot-Bilder. Im Ausführungsbeispiel werden die Bilder in den Parametern in Helligkeit augmentiert (Variierung der Bildhelligkeit der Bilder zum Training, um Helligkeitsschwankungen der Bilder bei der Anwendung des künstlichen neuronalen Netzwerkes in das Training einfließen zu lassen), und in Skalierung augmentiert (Variierung der Größe der Abbildung ähnlich einem Zoom, um Schwankungen der Größe der abgebildeten Slots und Wafer in Bildern bei der Anwendung des künstlichen neuronalen Netzwerkes, etwa durch geringe lagetoleranzbedingte Entfernungsunterschiede der Wafer und Slots zur Aufnahmeeinheit, in das Training einfließen zu lassen) augmentiert. Das Durchführen einer Augmentierung ist nicht zwingend. Die Anzahl der Bilder zum Trainieren des künstlichen neuronalen Netzes beträgt in dem Ausführungsbeispiel 150. Es können aber auch, etwa bei mehreren Parametern, die berücksichtigt werden sollen, und/oder bei mehreren möglichen Ausprägungen, deutlich mehr Bilder hilfreich sein, welche je nach Anwendung beispielsweise auch 10.000 betragen können.

In einem fünften Schritt werden die Bilder dann in Bilder zum Lernen ("Train"), und zum Testen und Validieren ("Test"-Bilder) der Iterationen des Trainingsvorganges aufgeteilt. Diese Zuordnung kann jedoch auch automatisch programmgesteuert erfolgen.

In einem sechsten Schritt (6) wird das künstlichen neuronalen Netz konfiguriert bzw. erstellt. Im vorliegenden Beispiel wird ein "CCN"-Netzwerk ausgebildet, also ein "Convolutional" Neuronales Netzwerk, welches unter anderem convolutionale und neuronale Layer enthält. Im Beispiel verfügt dieses Netzwerk über zwei Ausgangsneuronen, für die beiden definierten Klassen (belegter Slot, und freier Slot) stehen. Sind weitere Klassen erforderlich, wie beispielsweise die Klassen "cross slotted" oder "double slotted" Wafer, müssen entsprechende Neuronen hinzugefügt. Soll das Netzwerk auch Positionen bestimmen, so sind ebenso Neuronen hinzuzufügen, beispielsweise Neuronen für die 4 Ecken der die Position des Wafers umschließenden Bounding-Box. Alternativ oder ergänzend können auch beispielsweise ein FCN- Netzwerk oder ein RNN-Netzwerk oder auch weitere verwendet werden.

Im siebten Schritt (7) erfolgt der Lern-Vorgang. Das Netzwerk (6) führt den Lernvorgang mit den eingestellten Lernparametern (wie die Anzahl der Iterationen, auch "Epochs" genannt, Lernrate, und anderen für CNN Netzwerke bekannten Parametern durch.

Im Ergebnis des Lern-Vorganges wird schließlich wird im achten Schritt (8) das sogenannte "Weights-File" erzeugt, welches die Parametrisierung der einzelnen Elemente und Verbindungen des CNN-Netzwerkes enthält.

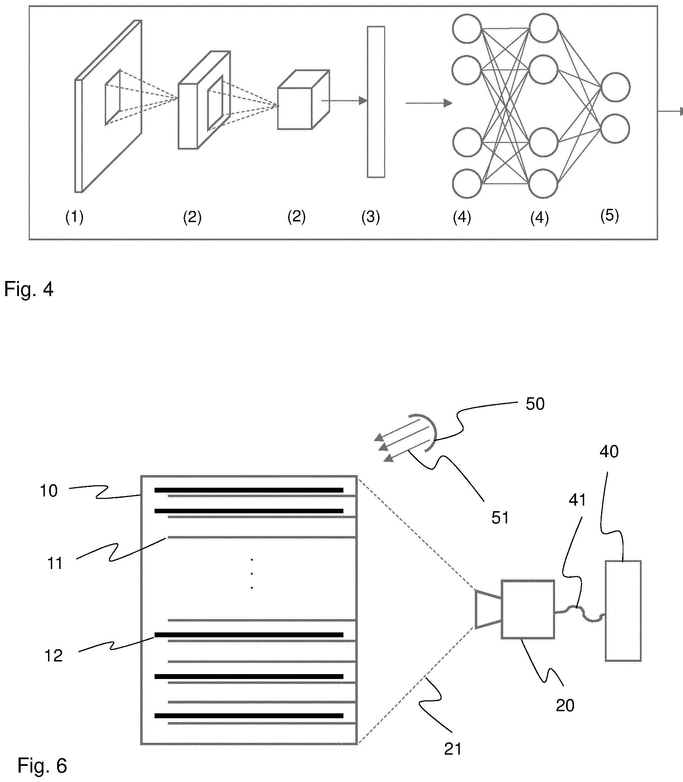

Fig. 4 zeigt schematisch den Aufbau dieses "CNN"-Netzwerkes bzw. ein Modell dieses Netzwerkes am Beispiel der Kassettenbelegung in einer stark vereinfachten Darstellung.

Hierzu dazu die sogenannte "Keras"-Plattform verwendet, es gibt jedoch eine Vielzahl andere möglicher Plattformen, beispielsweise "Pytorch" oder andere, die verwendet werden können.

Mit den Bezeichnungen (1) bis (5) sind in der Fig. 4 die verschiedenen Layer oder Hierarchieebenen angegeben.
(1) Input Layer: hier wird das Bild in das Netzwerk eingelesen.
(2) Convolutional Layer(s): Auf das Bild wird ein Faltungsvorgang mit verschiedenen Filter angewendet. Im Ausführungsbeispiel werden zwei Convolutional Layer verwendet, mit Filtergröße 3x3, Anzahl der Filter 32 - 64, ReLu Aktivierungsfunktion, Max Pooling mit Größe 2x2. Es ist jedoch eine Vielzahl anderer Konfigurationen möglich, etwa hinsichtlich der Anzahl der Layer, der Anzahl + Größe der Filter, oder der Aktivierungsfunktionen.
(3) Flatten Layer: Umwandlung des dreidimensionalen Ergebnisses des letzten Convolutional-Layers in ein eindimensionales Format zur Übergabe an die Neuronalen Layer.
(4) Neuronale Layer: es werden im Beispiel zwei neuronale Layer mit 128 und 64 Neuronen und ReLu Aktivierungsfunktion angewendet. Dropouts wurden eingesetzt, um eine Sättigung zu vermeiden. Es ist jedoch eine Vielzahl anderer Konfigurationen möglich, etwa hinsichtlich der Anzahl der Layer, der Anzahl der Neuronen, der Aktivierungsfunktionen, oder der Dropouts. Es ist auch möglich, ganz auf die Neuronalen Layer zu verzichten, was auch den Klassifikations-Layer betrifft. In diesem Fall kann die Klassifikation auch durch einen Convolutional-Layer erzeugt werden.
(5) Neuronaler Layer zur Klassifikation: Zwei Neuronen, für die Klassen Slot belegt und Slot frei. Im Lernprozess werden die Parameter des Netzwerkes durch iterativen Soll-Ist-Vergleich der erzeugten Klassifizierung optimiert, in der Anwendung der Klassifikation werden diese Parameter dann angewendet. Eine Softmax-Aktivierung wurde eingesetzt zur Erzeugung eines Float-Wertes zur Darstellung der Klassenzugehörigkeit des Bildes zu den beiden Klassen ("Scoring", Slot frei, Slot belegt). Wenn auch die Position des Wafers oder des Teils des Wafers bestimmt werden soll, sind entsprechend Neuronen für die Ecken der Bounding-Box hinzuzufügen.

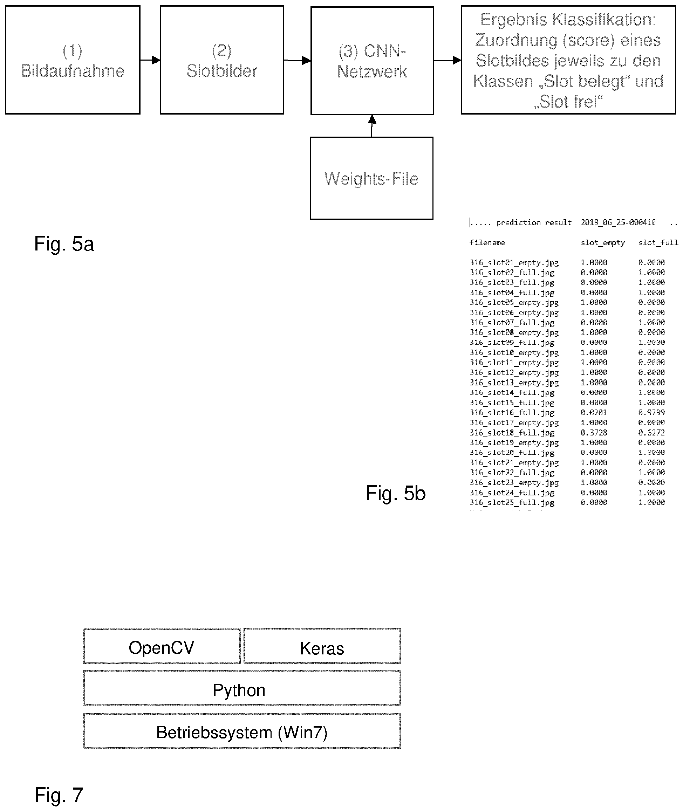

Fig. 5a zeigt schematisch die Anwendung des trainierten künstlichen neuronalen Netzes zur Erkennung einer Kassettenbelegung, und Fig. 5b ebenfalls schematisch einen Ausschnitt eines durch die Anwendung erzeugten Datensatzes mit Zuordnungen der einzelnen Slot-Bilder zu den Klassen "slot_empty" (slot ohne Wafer) und "slot_full" (Slot mit Wafer) zur Zugehörigkeit anhand des usführungsbeispiels, wobei die Zuordnung mit Werten zwischen 0 und 1 abgebildet ist.

Die einzelnen Schritte (1) bis (3) ergeben sich wie folgt:
(1) Ein Bild der geöffneten Kassette wird aufgenommen.
(2) Die einzelnen 25 Slot-Bilder werden erzeugt. Die entsprechenden Bildausschnitte der einzelnen 25 Slots werden automatisch aus dem Bild der geöffneten Kassette erzeugt. Dieses ist in dem gezeigten Ausführungsbeispiel und auch in praktischer Anwendung besonders gut möglich, wenn es eine feste geometrischen Zuordnung von Kamera und Kassette über vordefinierte Positionen gibt. Hier kann es sich also anbieten, dass die Aufnahmeeinheit ortsfest in Bezug auf die Maschine angeordnet ist.
   Es ist aber beispielweise auch möglich, die Lage der Kassette oder der Slots über beispielsweise Methoden der Objekt-Detektion, welche eine Ortserkennung umfassen, zu bestimmen, und daraus die Bildausschnitte abzuleiten.
(3) Das CNN-Netzwerk wie weiter oben beschrieben mit den Schritten "Trainieren des Netzwerkes" und "Aufbau des Netzwerkes" mit dem beim Anlernen des Netzwerkes erzeugten "Weights-File" parametrisiert. Die Slot-Bilder werden einzeln nacheinander im künstlichen neuronalen Netz analysiert, wobei die im Lernprozess erzeugte Filterung in den Convolutional Layern und die Verknüpfung in den Neuronalen Layern auf die einzelnen Bilder angewendet wird, und wobei durch den letzten Neuronalen Layer durch die den Klassen zugeordneten Neuronen die Zuordnung des Slot-Bildes zu den beiden Klassen (freier Slot, belegter Slot) vorgenommen wird. Dieser Vorgang wird auch als Prediktion bezeichnet.

Fig. 6 zeigt schematisch ein Ausführungsbeispiel eines weiteren Aufbaus mit einer Aufnahmeeinheit 20, einer Beleuchtungseinheit 50 sowie einer Rechnerarchitektur 40 in einer Draufsicht.

Die Aufnahmeeinheit 20 kann dabei dauerhaft fest, wie im Ausführungsbeispiel gezeigt, oder zeitweise fest in die Maschine integriert oder angebaut sein. Im Ausführungsbeispiel ist die Aufnahmeeinheit 20 dauerhaft fest im Umfeld der Maschine angeordnet. Die Verbindung mit der Rechnerarchitektur 40 kann in diesem Fall drahtgebunden mittels Kabel 41 erfolgen. Selbstverständlich sind auch drahtlose Verbindungen zwischen Rechnerarchitektur 40, Aufnahmeeinheit 20 und/oder Beleuchtungseinheit 30 möglich.

Die Aufnahmeeinheit 20 kann in Bezug auf das Handlingsystem und/oder den Ort der Bildaufnahme ortsunveränderlich installiert sein, wie im Ausführungsbeispiel gezeigt. Die Aufnahmeeinheit 20 oder auch eine weitere zweite Aufnahmeeinheit 20 kann aber auch an beweglichen Elementen des Handlingsystems angeordnet sein, bevorzugt an einem Roboterarm oder an einem Endeffektor eines Roboters oder an einer Verfahreinheit.

Im dargestellten Ausführungsbeispiel wurden die Bilder zum Trainieren und bei der Anwendung mit einer Kamera aufgenommen und an die Rechnerarchitektur 40 übertragen.

Es ist aber beispielswiese auch möglich, vorhandene, gespeicherte Bilder aus Datenbanken zum Trainieren zu verwenden. Es ist auch möglich, die Aufnahmeeinheit 20 für Bild- oder Videoaufnahmen zum Lernen und zur Anwendung des künstlichen neuronalen Netzes direkt mit der Rechnerarchitektur 40 zu verbinden, oder eine über ein Netzwerk angeschlossene Aufnahmeeinheit 20 zu verwenden.

Für bestimmte Anwendungsfälle kann bereits Raumbeleuchtung und damit das Umgebungslicht ausreichend sein. Im Allgemeinen ist es jedoch hilfreich, wenn eine Beleuchtungseinheit 50 wie im Ausführungsbeispiel gezeigt vorgesehen wird. Dies bietet sich insbesondere dann an, wenn innerhalb einer in der Regel geschlossenen Maschine, in die kein Umgebungslicht gelangt, Bilder aufgenommen werden sollen.

Die Beleuchtungseinrichtung 50 ist dazu vorgesehen, elektromagnetische Strahlung 51 in Richtung auf das Objekt oder den Ort zu emittieren, vorzugsweise zu dem Zeitpunkt, wenn ein Bild erfasst wird. Dabei liegt die elektromagnetische Strahlung 51 bevorzugt zumindest im sichtbaren Wellenlängenbereich und/oder in einem Wellenlängenbereich, in dem die Aufnahmeeinheit 20 sensitiv ist. Die Beleuchtungseinrichtung 50 kann eine Lampe, beispielsweise eine Lampe mit Leuchtdioden oder eine Halogenlampe, umfassen.

Die Beleuchtungseinrichtung 50 kann dabei in das Handlingsystem dauerhaft fest oder zeitweise fest integriert und/oder angebaut sein, oder auch in Bezug auf das Handlingsystem ortsunveränderlich installiert sein, wie im vorliegenden Ausführungsbeispiel. Alternativ oder zusätzlich kann die Beleuchtungseinrichtung 50 sich an beweglichen Elementen der Maschine befinden, bevorzugt an einem Roboterarm oder an einem Endeffektor eines Roboters oder an einer Verfahreinheit.

Die Rechnerarchitektur 40 kann unterschiedliche Rechnerkonfigurationen umfassen, beispielsweise einen PC, einen Industrie-PC, einen Embedded Controller, zum Beispiel Raspberry Computer, oder eine speicherprogrammierbare Steuerung SPS.

Es versteht sich, dass diese Rechnerkonfigurationen entsprechend dimensioniert sein sollten, um die erforderliche Rechenleistung zur Verfügung stellen zu können. Idealerweise erfolgt die Bild-Analyse durch das künstliche neuronale Netz dabei in Echtzeit oder zumindest nahezu in Echtzeit. Es versteht sich ferner, dass die entsprechenden Schnittstellen zur Kommunikation vorhanden sein sollten.

Fig. 7 zeigt schematisch ein Ausführungsbeispiel für eine geeignete Software-Architektur. Hierbei ist zu berücksichtigen, dass eine Vielzahl von Betriebssystemen, Umgebungen und Bibliotheken verfügbar sind, welche für das erfindungsgemäße Verfahren dienlich sein können. Die abgebildete Software-Architektur stellt damit nur ein Ausführungsbeispiel unter mehreren möglichen dar.

In dem Ausführungsbeispiel umfasst die Software-Architektur eine "Opencv"-Bibliothek. Diese wird verwendet zum Einlesen von Bildern, zur Verarbeitung von Bildern oder zur Generierung von Bildausschnitten. Alternativ können auch andere Bibliotheken oder Methoden für diese Aufgabe verwendet werden.

Ferner umfasst die Software-Architektur eine "Keras"-Bibliothek. Diese beinhaltet die für das Ausführungsbeispiel verwendeten Programmpakete des künstlichen neuronalen Netzes, wie beispielsweise zur Erstellung und Anwendung des CNN-Modells, oder zur Durchführung des Lernvorganges. Alternativ können auch andere Bibliotheken verwendet werden, wie beispielsweise "Pytorch", "Caffee", oder ähnliche.

Ferner umfasst die Software-Architektur eine "Python"-Umgebung zur Programmierung. Alternativ können auch andere Programmier-Umgebungen oder Programmiersprachen verwendet werden, wie beispielsweise C++, Java oder Mathlab.

Die vorstehend genannten Komponenten der Software-Architektur werden auch als Verarbeitungseinheit umfassend das künstliche neuronale Netz bezeichnet.

Schließlich basiert die Software-Architektur in dem Ausführungsbeispiel auf einem "Windows"-Betriebssystem.
Alternativ können auch andere Betriebssysteme verwendet werden, wie beispielsweise Linux, MacOS für Apple-Computer oder Raspbian für Raspberry-Computer.

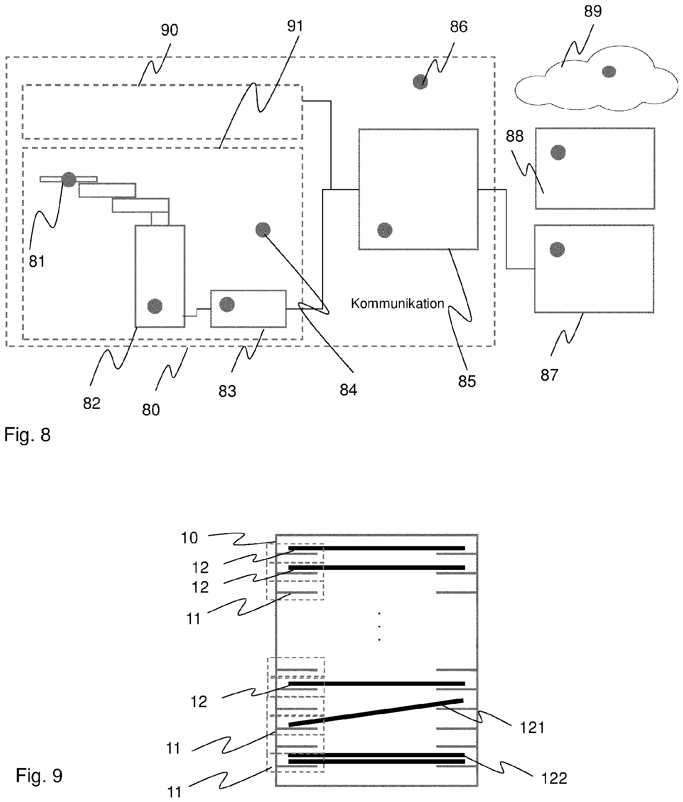

Fig. 8 zeigt schematisch ein Ausführungsbeispiel für den Aufbau einer Rechnerarchitektur und dessen Integration in ein Handlingsystem am Beispiel einer Maschine der Halbleiterindustrie, welche in dem Beispiel mit einer gestrichelten Linie 80 markiert ist.

So ist es im Sinne der Erfindung möglich und auch vorgesehen, die Rechnerarchitektur bzw. die zugehörigen Komponenten, umfassend die Verarbeitungseinheit, die Rechner-Hardware und das Betriebssystem des Rechners in geeigneter Weise zentral oder dezentral zu implementieren.

Hierbei können die Bestandteile der Verarbeitungseinheit, die Hardware-Komponenten, die Programme, Datenbanken, die Bedienung, die Datenspeicherung, oder auch andere Komponenten entweder auf einem Rechner zentral liegen, oder auch auf mehreren Rechnern oder verschiedenen Stellen verteilt sein.

Dies gilt auch für die einzelnen Verfahrensschritte im Zusammenhang mit dem künstlichen neuronalen Netz, wie das Generieren von Daten für den Lernprozess, das Trainieren oder die Anwendung des Verfahrens zur Bearbeitung von Substraten.

Anhand eines Beispiels soll die Integration des künstlichen neuronalen Netzes für die Erkennung von Masken und Pellicles veranschaulicht werden.

In dem Beispiel ist eine Kamera auf einem Endeffektor 81 vorgesehen. Die mindestens eine Kamera nimmt sowohl Bilder auf, welche zum Trainieren des künstlichen neuronalen Netzes verwendet werden, als auch die Bilder, welche während des Betriebs der Anlage für die Erkennung von Masken / Pelliclen benötigt werden.

Die Bilder zum Trainieren werden auf einen anderen, externen Rechner 88 übertragen, auf dem die Verarbeitungseinheit installiert ist und wo im Beispiel das CNN-Modell vorhanden ist. Das "Weights-File" wird nach dem Trainieren auf einen Roboter-Controller 83 übertragen, wo ebenfalls eine Verarbeitungseinheit installiert und das CNN-Modell vorhanden sind.

In der Anwendung, also während des Betriebs des Handlingsystems 91, liest die Kamera im Endeffektor 81 die Bilder ein und überträgt sie auf den Roboter-Controller 83, wo dann die Analyse mittels des künstlichen neuronalen Netzes ausgeführt wird.

Als Ergebnis wird ein Informationsdatensatz generiert mit einer Information darüber, ob eine Maske vorhanden ist oder nicht, ob ein Pellicle vorhanden ist oder nicht, und ggf. die Lage und die Orientierung des Pellicle. Diese Information wird dann an den Systemcontroller 85 übergeben, wo sie von der dort laufenden Anwendersoftware der Steuerung verwendet wird.

Die Verarbeitungseinheit kann demnach in dem Roboter 82, in oder an dem Endeffektor 81 mit integrierter Verarbeitungseinheit, aber auch in dem Roboter-Controller 83 mit integrierter Verarbeitungseinheit, in einer Rechnerarchitektur des Roboter-Handlingsystems 84 bzw. in dem Roboter-System 91 mit integrierter Verarbeitungseinheit, in einem Systemcontroller 85 mit integrierter Verarbeitungseinheit, in einer Rechnerarchitektur der Maschine der Halbleiterindustrie 86 mit integrierter Verarbeitungseinheit, in einer der Maschine nicht zugeordneten Steuerung 87 mit integrierter Verarbeitungseinheit, etwa einer Fabriksteuerung, oder einem anderen Rechner 88 mit integrierter Verarbeitungseinheit oder auch in einer Cloud 89 integriert sein.

Nachfolgend werden verschiedene Beispiele angegeben, welche verschiedene Arten von typischen Fehllagen von Substraten darstellen sollen.

So zeigt die Fig. 9 schematisch das Ausführungsbeispiel aus Fig. 1 mit einer geöffneten Kassette als Speicher 10 mit insgesamt drei Substraten 12 in korrekter Lage an jeweils einem Ablageort 11. Die Bezugszeichen 121 und 122 kennzeichnen jeweils ein Substrat 12 in Fehllage. Im Fall des Substrates 121 handelt es sich um einen Wafer, welcher in einer sogenannten "cross-slotted"-Lage aufgelegt ist, also schräg über zwei Ablageorte liegt. Im Fall des Substrates 122 handelt es sich um zwei Wafer, welcher in einer sogenannten "double-slotted"-Lage in einem Ablageort 11 liegen. In beiden Fällen handelt es sich um eine Fehllage, die ein weiteres Prozessieren der Substrate verhindern und ein manuelles Eingreifen durch einen Bediener erfordern kann.

Für die Erkennung der dargestellten Fehllagen werden beispielsweise
- Slot-Bilder mit korrekter Platzierung der Wafer aufgenommen
- Slot-Bilder mit der Fehllage "cross-slotted" aufgenommen
- Slot-Bilder mit der Fehllage "double-slotted" aufgenommen

Das Modell des künstlichen neuronalen Netzes kann mit den Klassen "Slot ohne Wafer", "Slot mit korrekt aufgelegten Wafer", "Slot mit double-slotted Wafer" und "Slot mit cross -slotted Wafer" definiert werden. Das Modell kann entsprechend trainiert und das "Weights-File" kann erstellt werden. Damit kann das künstliche neuronale Netz
zur Erkennung des Mappings der Kassette und von Fehllagen im Betrieb des Handlingsystems verwendet werden.

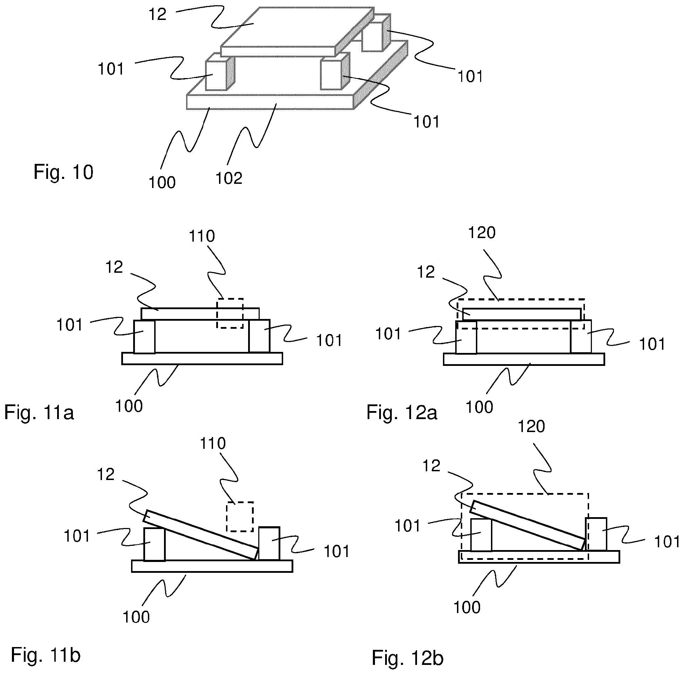

Fig. 10 zeigt schematisch ein Ausführungsbeispiel einer Auflage 100 für Substrate 12 mit aufgelegtem Substrat 12 in korrekter Lage in einer Schrägansicht. Die Auflage 100 umfasst insgesamt vier an den Ecken gelegene Aufnahmepunkte 101, auf denen bei korrekter Lage das Substrat 12, im Beispiel ein Wafer, aufliegen soll.

Die Figuren 11a und 11b zeigen schematisch ein Ausführungsbeispiel der Aufnahme für Wafer mit einem aufgelegten Wafer in korrekter Lage (Fig. 11a) und in Fehllage (Fig. 11b), welches auf der Auflage 100 aus Fig. 10 basiert, in einer Draufsicht. Das Beispiel soll die im Stand der Technik vorherrschenden Probleme bei der Verwendung einer regelbasierenden Bildverarbeitung zur Erkennung einer Maske verdeutlichen.

Ein regelbasierendes Verfahren erfordert, wie im Beispiel gezeigt, die Festlegung eines diskreten Bereiches, welcher im Beispiel mit der gestrichelten Umrahmung 110 definiert ist. Während das aufgelegte Substrat 12 in Fig. 11a mittels des regelbasierenden Bilderkennungssystems erkannt werden kann, führt die Fehllage in Fig. 11b nicht dazu, dass ein Substrat 12 erkannt wird, da sich das Substrat 12 außerhalb des definierten, diskreten Bereiches 110 befindet.

Fig. 12a, 12b zeigen schematisch ein weiteres Ausführungsbeispiel einer Aufnahme für Wafer mit einem aufgelegten Wafer in korrekter Lage (Fig. 12a) und in Fehllage (Fig. 12b), wobei anstelle einer regelbasierenden Bilderkennung ein künstliches neuronales Netz verwendet wird. Dies kann ein CNN-Netzwerk sein wie weiter oben dargestellt, oder auch ein anderes. Zum Anlernen und zur Detektion kann bei einer Bilderkennung mittels künstlicher neuronaler Netz gemäß der Erfindung schematisch ein Bildausschnitt 120 der gesamten Maske verwendet. Auf diese Weise ist es möglich, dass auch ein Substrat 12 erkannt werden kann, welches deutlich von seiner Soll-Lage abweicht. In diesem Beispiel weist das Substrat 12 hinreichende Merkmale eines typischen Substrates 12 auf, welches eine Zuordnung, auch bei einer deutlichen Fehllage, erlaubt.

Die Maske in dem Beispiel der Fig. 12b wird demnach erkannt, obwohl sie eine Fehllage hat. Je nach Auslegung des künstlichen neuronalen Netzes kann auch eine Klassifikation erfolgen, dass es eine Maske mit Fehllage ist.

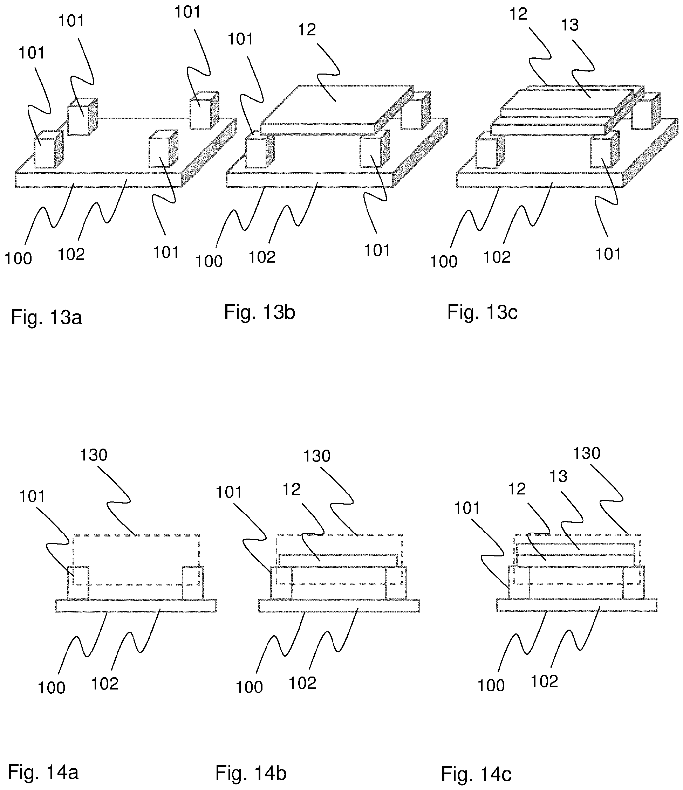

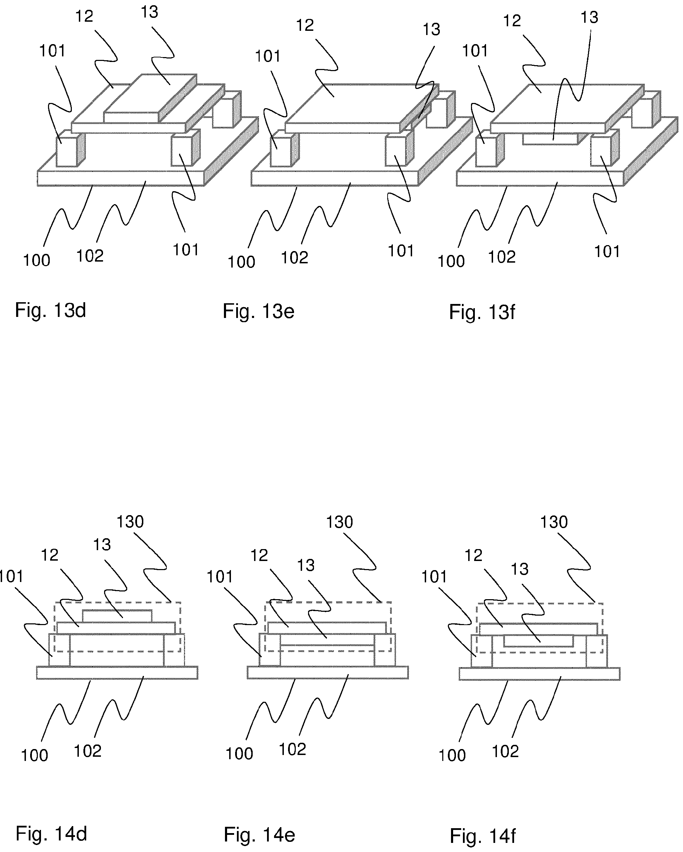

Die Figuren 13a, 13b, 13c, 13d, 13e und 13f zeigen schematisch verschiedene typische Ausführungsformen einer Auflage 100 für Substraten 12 in einer Schrägansicht. Im vorliegenden Beispiel handelt es sich bei dem Substrat 12 um eine Maske, welche ohne Pellicle 13 (Fig. 13b) bzw. mit Pellicle 13 (Figs. 13c bis 13f) gezeigt ist. Fig. 13a zeigt die Auflage 100 ohne Substrat 12.
In Fig. 13c ist das Pellicle 13 oben auf der Maske quer zur Vorderseite 102 der Auflage 100 angeordnet, in Fig. 13d ist das Pellicle 13 oben auf der Maske längs angeordnet, beziehungsweise die Maske mit dem Pellicle ist derart orientiert, dass das Pellicle quer auf der Oberseite liegt.

In Fig. 13e ist das Pellicle 13 unten auf der Maske quer zur Vorderseite 102 der Auflage 100 angeordnet, in Fig. 13f schließlich ist das Pellicle 13 unten auf der Maske längs angeordnet. Die Bezeichnungen "oben" bzw. "unten" bezieht sich dabei auf ein abgelegtes Substrat, wobei "unten" dann zum Boden hinweist. Die Bezeichnungen "längs" und "quer" beziehen sich auf die Vorderseite 102 der Auflage 100.

Die Figuren 14a, 14b, 14c, 14d, 14e und 14f zeigen dazu korrespondierend schematisch die jeweiligen Bildausschnitte 130, welche das künstliche neuronale Netz zur Pellicle Detektion verwendet. Es wären auch Teile der dargestellten Bildausschnitte möglich, sofern diese die Situation eindeutig beschreiben; beispielsweise wäre auch die rechte oder linke Hälfte der Bilder ausreichend.

Im Beispiel der Fig. 14a, korrespondierend zu dem Beispiel der Fig. 13a, wird etwa erkannt, dass kein Substrat 12 auf der Auflage 100 vorhanden ist, im Beispiel der Fig. 14b wird ein Substrat ohne Pellicle erkannt, korrespondierend zu dem Beispiel der Fig. 13b.

Die vorstehend erläuterten Beispiele zeigen allein anhand zweier einfacher Parameter "Substrat vorhanden/nicht vorhanden", sowie "Pellicle vorhanden/nicht vorhanden" bzw. in welcher Lage ein erkanntes Pellicle vorliegt, die Komplexität, die ein regelbasierendes Verfahren erfordern würde, bei dem jede Lage in entsprechenden Regeln hinterlegt werden müsste.

Ändert sich dann ein Systemparameter, beispielsweise dahingehend, dass ein neuer Endeffektor in der Maschine der Halbleiterindustrie installiert wird, der auch leicht schräg liegende Substrate 12 greifen und transportieren kann, beispielsweise bis zu einer Schräglage des Substrates in einem Winkel von bis zu 5°, 10° oder 15° gegenüber der Horizontalen, müssten sämtliche Regeln neu definiert und hinterlegt werden, was zu einem immensen Aufwand führen kann.

Die Verwendung eines künstlichen neuronalen Netzes im Sinne der Erfindung ermöglicht es dagegen, anhand weniger Bilder, die die entsprechenden Schräglagen des Substrates 12 zeigen, das künstliche neuronale Netz neu bzw. ergänzend zu trainieren und damit die Effizienz der Maschine der Halbleiterindustrie signifikant und in kurzer Zeit zu verbessern.

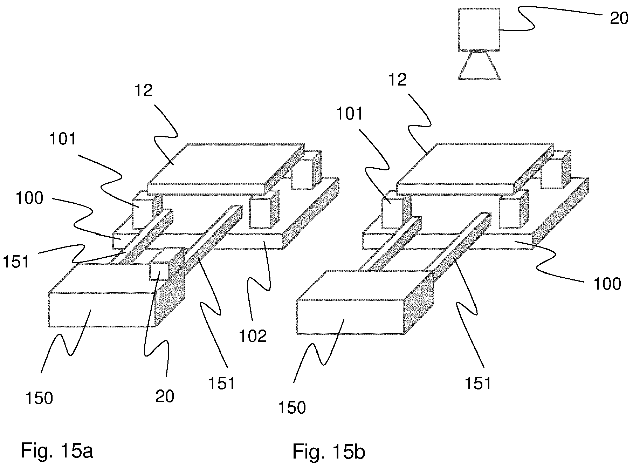

Die Figuren 15a und 15b zeigen schematisch ein weiteres Ausführungsbeispiel mit unterschiedlicher Anordnung der Aufnahmeeinheit 20 in einer Schrägansicht.

In dem Ausführungsbeispiel der Fig. 15a ist die Aufnahmeeinheit 20, im Beispiel eine bildgebende Kamera, an einem Endeffektor 150 angeordnet. Von Vorteil ist sie derart angeordnet, dass zumindest ein Greifarm 151 im Bildfeld der Aufnahmeeinheit 20 liegt.

In dem Ausführungsbeispiel der Fig. 15b ist die Aufnahmeeinheit 20, im Beispiel ebenfalls eine bildgebende Kamera, an einer nicht veränderlichen Stelle in Bezug auf das Handlingsystem angebracht.

Von Vorteil ist die Aufnahmeeinheit 20 derart angeordnet, dass zumindest die relevanten Objekte, insbesondere die Auflage 100, oder der Roboter oder ein bestimmter Bereich von Interesse im Bildfeld der Aufnahmeeinheit 20 liegt.

Der Roboter und der Roboterarm sind in den Ausführungsbeispielen der Übersichtlichkeit halber nicht gezeigt. Es können auch mehrere Aufnahmeeinheiten 20 in verschiedenen Ausrichtungen angebracht werden, deren Bilder zusammengesetzt und dann ausgewertet werden, oder deren Bilder einzeln ausgewertet werden, und dann die Ergebnisse der Auswertung miteinander verbunden werden.

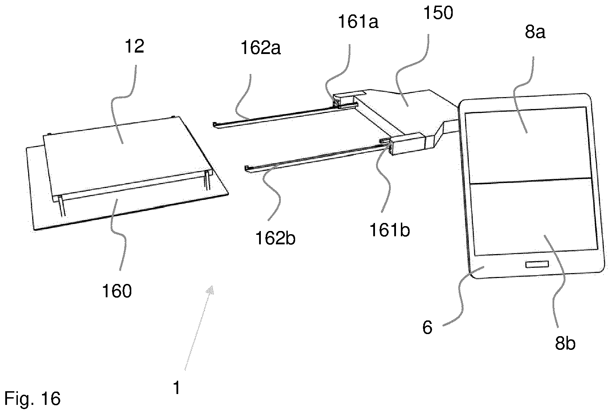

Fig. 16 zeigt in einer schematischen Ansicht ein Handlingsystem 1 zur Prozessierung von Halbeiterbauelementen.

Das Handlingsystem 1 umfasst einen Endeffektor 150 mit den Armen 162a, 162b über die ein Substrat 12, im Beispiel eine Maske oder ein Wafer, auf einer Ablage 160 abgesetzt und/oder aufgenommen werden kann.

Der Endeffektor 150 ist Teil eines Roboters (nicht dargestellt) und wird über den Roboter in mehreren Raumrichtungen bewegt. Insbesondere kann ein Roboter mit einer Radial- und Theta-Achse verwendet werden.

Gemäß der Erfindung umfasst das System zumindest eine Aufnahmeeinheit, welche in diesem Ausführungsbeispiel mitbewegend am Endeffektor 150 angeordnet ist.

In diesem Ausführungsbeispiel sind zwei Kameras 161a, 161b, als Aufnahmeeinheit vorgesehen. Die optischen Achsen der zwei Aufnahmeeinheiten können in einem Winkel zueinander stehen, oder auch parallel zueinander ausgerichtet sein. In dem Ausführungsbeispiel sind die beiden optischen Achsen der beiden Aufnahmeeinheiten parallel zueinander ausgerichtet, aber seitlich voneinander versetzt, um beide Arme 161a, 161b abbilden zu können.

Die Kameras 161a, 161b, befinden sich in diesem Ausführungsbeispiel vorne am Endeffektor 150 zwischen oder neben den Armen 162a, 162b.

Das Bild der Kameras 161a, 161b wird an ein elektronisches Gerät, in diesem Ausführungsbeispiel an ein tragbares Tablet 6, übertragen.

In diesem Ausführungsbeispiel sind auf dem Tablet die Ansichten der Kameras 161a, 161b getrennt als Ansicht 8a und Ansicht 8b dargestellt. Die kann beispielsweise über einen geteilten Bildschirm realisiert sein.

Beispielsweise ist es möglich, dass die Kamera 161a auf den Arm 162a gerichtet ist, wohingegen die Kamera 161b auf die vordere Kante des Substrates 12 gerichtet ist.

So kann zum einen über die Kamera 161a der Bewegungsverlauf des Endeffektors 150 kontrolliert werden.

Über die Kamera 161b kann auf einfache Weise festgestellt werden, wenn es zu einem Versatz beim Aufnehmen oder Ablegen des Substrates 12 kommt, oder ob sich das Substrat 12 in einer Position befindet, beispielsweise in einer Schräglage von 2° oder 5°, welche noch ein Prozessieren ermöglicht.

Weiter kann über die Kameras 161a, 161b überprüft werden, ob sich ein Substrat 12 auf dem Endeffektor 150 befindet. Auf weitere Sensoren kann so verzichtet werden.

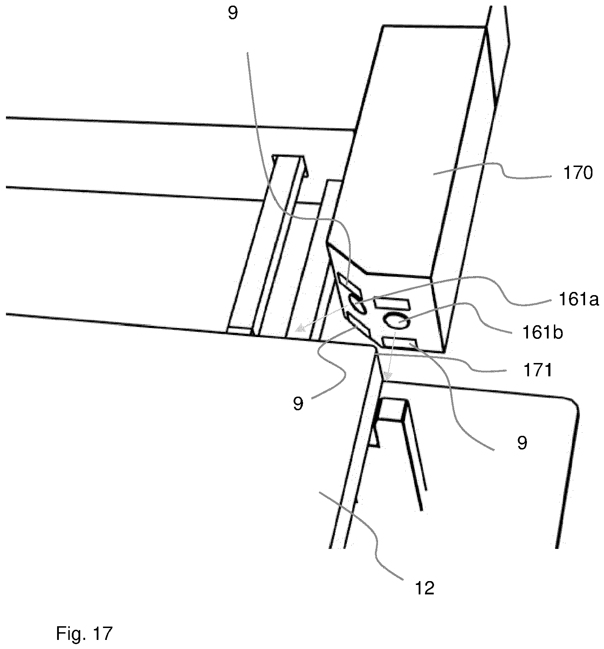

Fig. 17 zeigt ein Ausführungsbeispiel, bei welchem in einem einzigen Kameragehäuse 170 zwei Kameras 161a, 161b an einer Ecke angeordnet sind.

Zu erkennen ist, dass jede der Kameras 161a, 161b die von der Ecke 16 ausgehende Kante aufnimmt. Von Vorteil sind die beiden Kameras 161a, 161b derart angeordnet, dass ihre Blickrichtungen bzw. ihre optischen Achsen nicht parallel zueinander stehen, sondern einen Winkel zueinander bilden.

Der Winkel der optischen Achsen kann dabei in einer Ebene gebildet werden, welche durch die beiden Arme 162a und 162b, also der Greifvorrichtung des Endeffektors, vorgegeben ist. Im Ausführungsbeispiel liegt die optische Achse der zumindest einen Aufnahmeeinheit in dieser Ebene, um zumindest den einen Arm 162a, 162b gut abbilden zu können. Es ist aber auch möglich, dass die optische Achse der zweiten Aufnahmeeinheit nicht in dieser Ebene liegt. So kann etwa auch bei Annäherung an ein Objekt früher festgestellt werden, ob eine Kollision droht.

Dieser Winkel kann unterschiedlich ausgeführt sein und liegt von Vorteil zwischen 5° und 90°, bevorzugt zwischen 10° und 80° und besonders bevorzugt zwischen 15° und 75°. Im Beispiel beträgt der Winkel zwischen etwa 20° bis 30°. Diese Bauweise ermöglicht einen besonders kompakten Aufbau des Kameragehäuses 170 und damit eine einfache und platzsparende Montage an dem Endeffektor.

So kann ebenfalls auf einfache Weise ein Versatz beim Aufnehmen oder Ablegen festgestellt werden.

Vorzugsweise ist das Kameragehäuse 170 am Endeffektor angebracht.

Auf diese Weise kann eine kompakte, einfach zu integrierende Möglichkeit geschaffen werden, die Aufnahmeeinheiten am Endeffektor anzuordnen, so dass sie mit dem Endeffektor bewegt werden können und dabei gleichzeitig im Betrieb bzw. bei der Bewegung des Endeffektors die erforderlichen Informationen bereitstellen können.

Das Kameragehäuse 170 kann des Weiteren jeweils eine Beleuchtung 9 (z.B. LEDs) für das Sichtfeld der Kameras 161a, 161b umfassen. Die Beleuchtung 9 ist dabei vorzugsweise derart angeordnet, dass die Haupt-Abstrahlrichtung des Lichtes parallel zu der Blickrichtung der Kameras 161a, 161b verläuft.

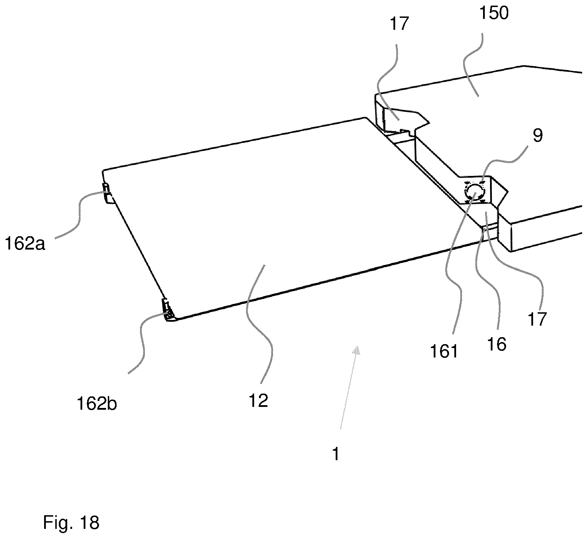

Fig. 18 zeigt ein Ausführungsbeispiel, bei welchem eine Kamera 161 mit integrierter Beleuchtung 9 im Endeffektor 150 integriert ist.

Hierzu umfasst der Träger des Endeffektors 150, aus welchem die Arme 162a, 162b hervorstehen, eine Einbuchtung 17, innerhalb der die Kamera 161 angeordnet ist. Die Kamera 161 ist bei dieser Ausführungsform der Erfindung schräg in das Gehäuse des Endeffektors 150 eingebaut.

So nimmt die Kamera 150, welche ein stabförmiges Gehäuse (nicht dargestellt) aufweisen kann, größtenteils ansonsten ungenutzten Raum im Gehäuse des Endeffektors 150 ein. Weiter kann durch die schräge Anordnung ein großes Sichtfeld bereitgestellt werden. Die optische Achse der Kamera 161 kann insbesondere einen Winkel von 30 bis 60° zur Haupterstreckungsrichtung der Arme 162a, 162b einnehmen.

Die zumindest eine Kamera 161 befindet sich in der Einbuchtung 17 in einer schräg verlaufenden Fläche, so dass die Kamera auf die Ecke 16 des Substrates 12 gerichtet ist.

Es versteht sich, dass in der zweiten Einbuchtung 17 vorzugsweise ebenfalls eine Kamera vorhanden ist oder sein kann, welche in dieser Ansicht verdeckt ist.

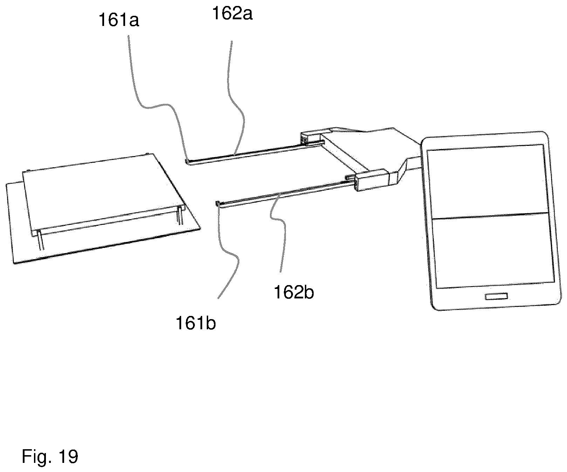

Fig. 19 zeigt eine weitere Ausführungsform der Erfindung, bei welcher die Kameras 161a, 161b an den Armen 162a, 162b des Endeffektors 150 angeordnet sind.

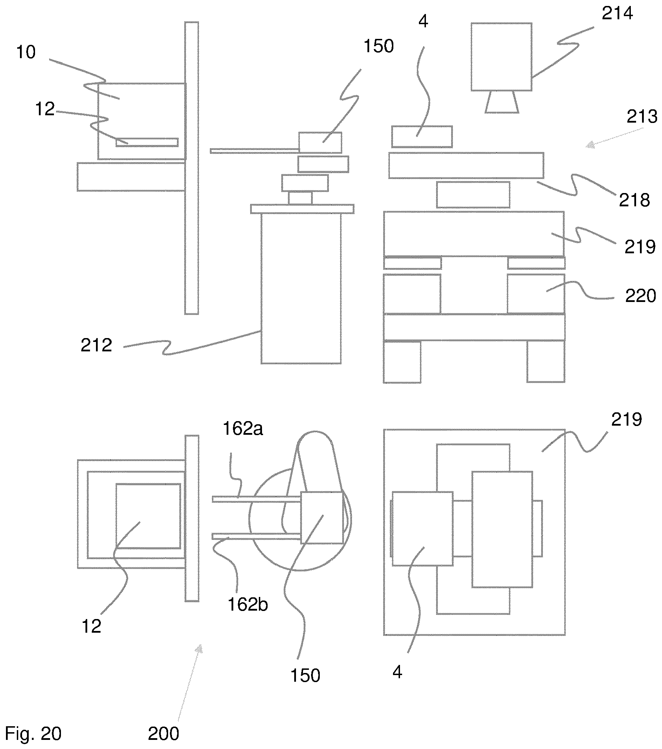

Fig. 20 zeigt in einer Seitenansicht und einer darunter dargestellten Draufsicht von oben wesentliche Bestandteile einer Maschine 200 der Halbleiterindustrie zur Prozessierung von Halbleiterbauelementen als Beispiel eines Handlingsystems.

Die Maschine 200 umfasst einen Speicher 10, im Beispiel eine Kassette, für Substrate 12, im abgebildeten Fall für Masken, welcher im abgebildeten Fall insbesondere als FOUP ("front opening unified pod") abgebildet ist, welcher mit einem SMIF ("standard mechanical interface") Loadport geöffnet oder geschlossen wird.

Mittels eines Roboters 212 mit dem Endeffektor 150 können dem Speicher 10 Substrate 12 entnommen und an die Bearbeitungsstation 213 weitertransportiert werden.

Die Bearbeitungsstation 213 umfasst in diesem Ausführungsbeispiel eine verfahrbare Bühne 218 ("Stage"), auf welcher sich als Aufnahme für die Maske ein Chuck befindet.

Die hier darstelle Maschine zur Prozessierung von Masken kann insbesondere ein Inspektionsgerät 214 umfassen, welches sich auf einer Platte 219 befindet, die schwingungsisoliert von den Isolatoren 220 abgestützt wird.

Zumindest der Endeffektor 150 des Roboters 212 umfasst eine Kamera, mittels der der Roboter 212 im Betrieb Bilder erfassen kann und welche durch das künstliche neuronale Netz verarbeitet werden.

Hierdurch kann gleichzeitig die Belegung des Speichers 10 mit Substraten 12 geprüft werden. Der Roboter 212 fährt so nur Aufnahmen an, in denen sich auch ein Substrat 12 in einer gewünschten Position und Orientierung befindet. In dieser Darstellung befindet sich die dargestellte Anlage im Ruhezustand.

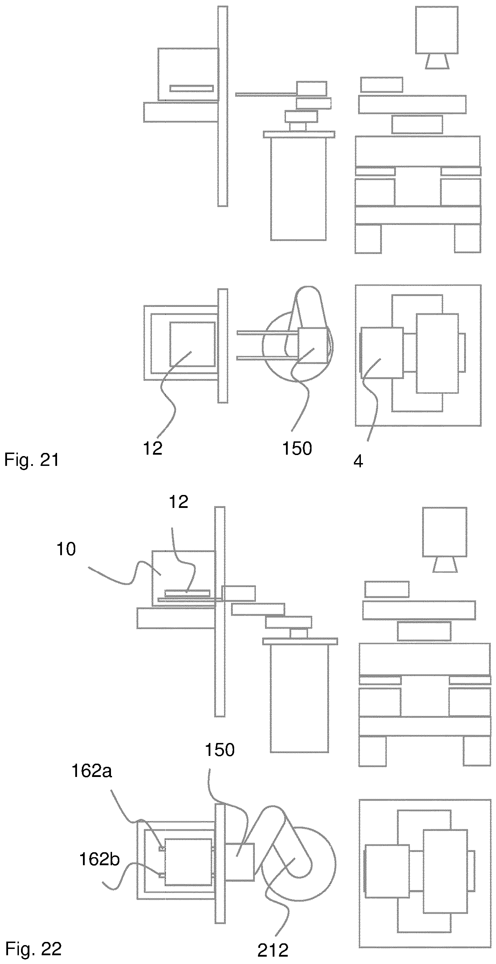

Fig. 21 zeigt die in Fig. 20 dargestellte Anlage im Ruhezustand. Wie in Fig. 20 dargestellt, wird zur Aufnahme des Substrates 12 bzw. der Maske aus dem Speicher 10 bzw. der Kassette der Endeffektor mit seinen Armen 162a, 162b unter die Maske gefahren.

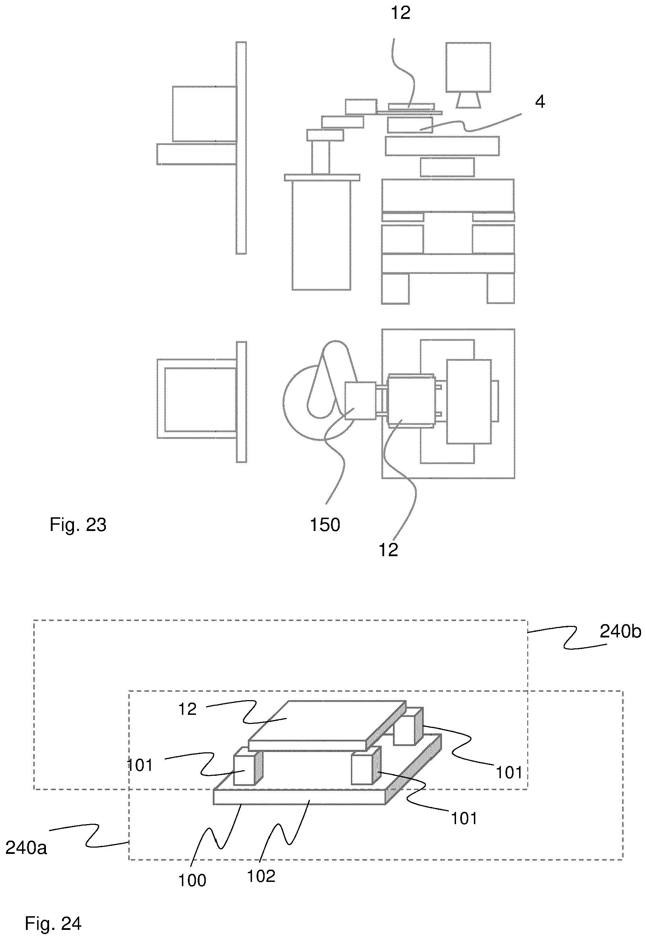

Die Maske wird mit dem Roboter 212 angehoben (Fig. 22) und in die Fig. 23 dargestellte Zielposition auf der Ablage 4 verfahren. Die Zielposition wird von der am Endeffektor angeordneten Kamera kontrolliert.

Die Maschine der Halbleiterindustrie kann auch eine Vakuumkammer enthalten. Es versteht sich, dass die erfindungsgemäßen Verfahren auch innerhalb von Vakuumkammern ausgeführt werden können, sofern die Komponenten, wie beispielsweise die Aufnahmeeinheit oder die Beleuchtung, soweit erforderlich, und/oder soweit sie sich innerhalb einer Vakuumkammer befinden, vakuumtauglich ausgeführt sind. Ein besonderer Vorteil der Anwendung von Kameras in Vakuumkammern ist es, dass es möglich ist, beispielsweise Roboter in der Vakuumkammer zu teachen, oder das Teachen zu kontrollieren, ohne die Vakuumkammer öffnen zu müssen. Ein Öffnen der Vakuumkammer ist immer damit verbunden, dass Vakuum aus der Kammer zu evakuieren (sofern vorher Vakuum vorlag), und wieder aufzubauen. Dies kann sehr lange dauern, beispielsweise viele Stunden, in welcher die Maschine nicht bestimmungsgemäß nutzbar ist.

Beispielsweise über Clips kann die Aufnahmeeinheit 20 werkzeuglos installiert werden.

Mittels der Bilderkennung durch das künstliche neuronale Netz kann eine hochpräzise und effiziente Steuerung der Maschine der Halbleiterindustrie oder eines Endeffektors eines Roboters erreicht werden.

Das erfindungsgemäße Verfahren ermöglicht damit die Bearbeitung von Substraten, insbesondere von Wafern, Masken oder Flat Panel Displays.

Ergänzend kann vorgesehen sein, einen Endeffektor zu verwenden, bei welchem die Positionierung des Substrates, also der Masken, des Wafers oder des Flat Panel Displays, auf die Aufnahme durch im Endeffektor integrierte Motoren, beispielsweise mittels eines Piezos, erfolgt. So ist eine genauere Positionierung des Substrates möglich, als über den entfernten Antrieb im Roboter. Bei einer weiteren Ausführungsform der Erfindung umfasst also der Endeffektor selbst Aktoren zur Feinjustierung der Zielposition.

Hier kommen insbesondere die Vorteile bei einer Verwendung des künstlichen neuronalen Netzes zum Tragen, welche es ermöglichen, auch tolerierbare und einfach nachjustierbare Abweichungen von Soll-Lagen des Substrates, also Abweichungen von einem ideal abgelegten Substrat, zu erkennen und zu entscheiden, ob und unter welchen Anpassungen des Endeffektors eine Bearbeitung oder Prozessierung möglich ist.

Auch der Roboter selbst kann, wie es bei einer Ausführungsform der Erfindung vorgesehen ist, über die Bilderkennung in seinem Bewegungsablauf feinjustiert werden.

Anhand der folgenden Figuren soll das Trainieren eines Handlingsystems nochmals verdeutlich werden.

Fig. 24 zeigt anhand eines Ausführungsbeispiels das Anlernen eines Roboters in einer Schrägsicht. Mittels des künstlichen neuronalen Netzes wird wie in dem Ausführungsbespiel gezeigt eine Klassifikation, also Erkennung, und/oder eine Detektion, also eine Erkennung und Lokalisierung, eines Substrates 12, im Beispiel einer Maske, angelernt. Dazu können im Lernprozess z.B. Bilder 240a verwendet werden, welche die Maske und die Auflage 100 vollständig abbilden, oder auch Bilder 240b, welche die Maske an verschiedenen Stellen bzw. die Auflage 100 nur in Ausschnitten abbilden.

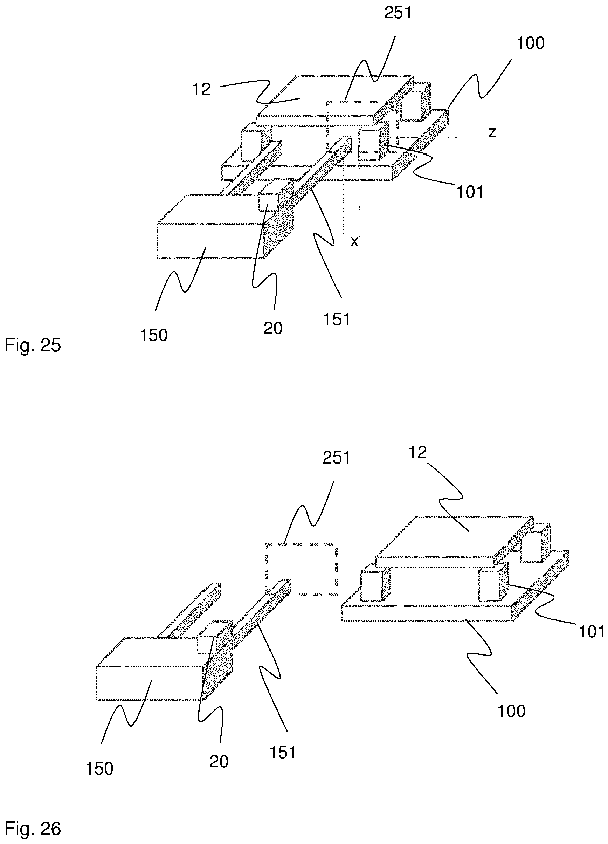

Fig. 25 zeigt ein weiteres Ausführungsbeispiel einer Anordnung zum Anlernen eines Roboters in einer Schrägsicht. In dem Ausführungsbeispiel wird eine am Endeffektor 150 eines Roboters für ein Maskenhandling angebrachte Aufnahmeeinheit 20, im Beispiel eine bildgebende Kamera, dazu verwendet, den Anlern-Vorgang in der Weise zu unterstützen, dass über die Kamera die Teaching-Position in Bezug auf die Zielposition, im Beispiel die Ablage 100 eines Substrates 12, im Beispiel eine Maske, und die Maske in den translatorischen Richtungen x und z unter anderem durch eine Bildverarbeitung kontrolliert werden kann.

Insbesondere sollen dabei die Abstände x (horizontaler Abstand zwischen dem Ende des Endeffektors und der linken Kante des Aufnahmepunktes 101), und z (vertikaler Abstand zwischen dem Ende des Endeffektors und der unteren Kante der Maske) kontrolliert werden. Die dazu vordefinierten und zu detektierenden Eigenschaften der Auflage 100 und der Maske, z.B. deren Kanten, liegen dazu in einem engen vordefinierten Bereich, dem Auswertebereich 251 der Bilderkennung, wobei die Bilderkennung in diesem Auswertebereich zur Erkennung der genannten Kanten im Auswertebereich und von deren Position zur Bestimmung der Abstände x und z programmiert ist.

Wenn jedoch, wie in dem Ausführungsbeispiel der Fig. 26 gezeigt, der Roboter beim Trainieren in stärkerer Abweichung von der vordefinierten Position steht, beispielsweise zu Beginn des Trainierens, wo noch gar keine Positionen trainiert wurden, oder durch einen Fehler des Roboters, oder durch eine Fehlbedienung, dann kann es vorkommen, dass in dem vordefinierten Auswertebereich 251 der Erkennung keine vordefinierten Eigenschaften der Maske vorhanden sind, zum Beispiel weil mit einer starken Abweichung des Roboters auch das Bild der auf dem Endeffektor montierten Kamera eine starke Abweichung aufweist. Somit liegen die in Fig. 25 beschriebenen Kanten zur Bestimmung der Abstände x und z nicht mehr im Auswertebereich 251, und können somit nicht erkannt werden, und es können somit die Abstände x und z nicht ermittelt werden.

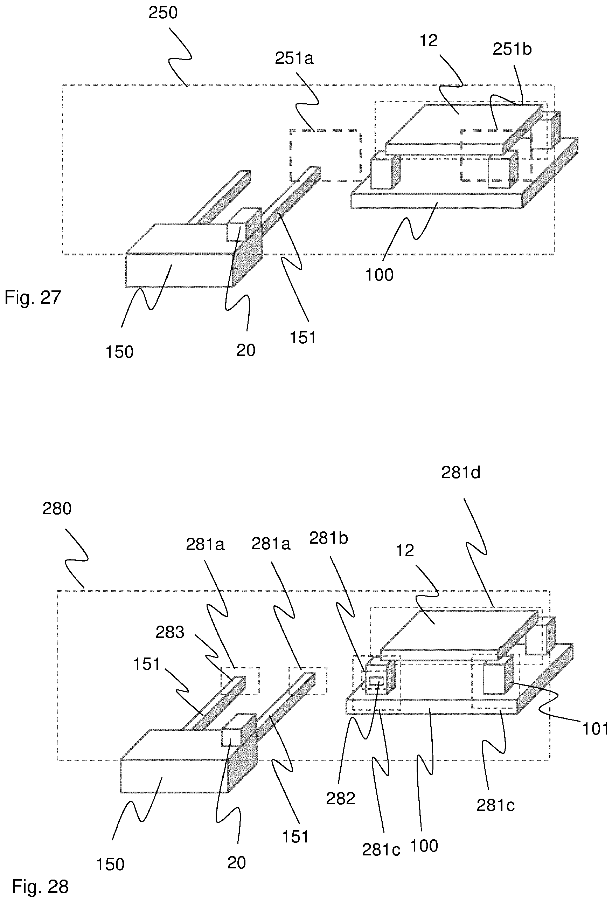

Fig. 27 zeigt, aufbauend auf dem Beispiel aus Fig. 26, die Vorteile bei Verwendung eines künstlichen neuronalen Netzes im Zuge der Klassifikation und Detektion von Objekten, an einem weiteren Ausführungsbeispiel zum Anlernen eines Roboters in einer Schrägsicht. Beim Trainieren und insbesondere Anwenden kann ein größeres Bildfeld 250 verwendet werden, so dass bei größerer Abweichung des Roboters von einer vordefinierten Position über die Klassifikation festgestellt werden kann, ob im Bild ein Substrat 12, im Beispiel eine Maske, vorhanden ist, oder über eine Detektion, wo sich die Maske befindet. Die Detektion liefert dann eine zumindest ungefähre Position der Maske im Bild, die es ermöglicht, die x/z - Distanz des Roboters zu einer vordefinierten Position im Bild zu bestimmen und
a) den Roboter in eine Position wie in Fig. 25 gezeigt zu fahren (Offset x/z), und aus dieser Position heraus die Werte x und y (Abb. 110) zu bestimmen, oder
(b) Den Bildausschnitt 251a, also den Auswertebereich der Erkennung der regelbasierenden Bildverarbeitung, über den Offset x/y an die richtige Stelle zu legen, so dass der Bildausschnitt 251b analysiert wird. Hierzu ist es von Vorteil, ein möglichst großes Bildfeld 250, zumindest in einem ersten Schritt und damit als erstes Bild, zu verwenden.

Fig. 28 zeigt ein weiteres Ausführungsbeispiel, welches das Erkennen mehrerer Objekte im Bild verdeutlichen soll.

Mittels des künstlichen neuronalen Netzes können mehrere Objekte im Bild erkannt und deren Positionen bestimmt werden. Die Objekte können auch Markierungen 282 auf anderen Objekten sein, zum Beispiel Aufkleber oder Labels, die auf einem Aufnahmepunkt 101 angebracht sind. Die Objekte können auch weitere Teile der Maschine sein, wie im Beispiel die Enden 283 eines Endeffektors 150. In dem Bildfeld 280 der Kamera können in den mit gestrichelter Umrandung dargestellten Auswertebereichen die folgenden Objekte erkannt werden:
- Ende Endeffektor 281a,
- Markierung 281b,
- Aufnahmepunkt 281c,
- Maske 281d.

Wenn die durch die Detektion des künstlichen neuronalen Netzwerkes erreichte Genauigkeit der Positionsbestimmung bereits ausreicht, kann auch auf die Anwendung der regelbasierenden Bildverarbeitung verzichtet werden.

Weiterhin können unter Anwendung geometrischer Berechnungsverfahren alle Positionen und Abstände von Objekten und/oder Substraten in allen translatorischen und rotatorischen Freiheitsgraden bestimmt werden (nicht nur x und z), sofern die für die geometrischen Berechnungen notwendigen Positions- oder Abstandsinformationen von Objekten und/oder Substraten oder von Teilen davon vorliegen und/oder durch künstliches neuronales Netz oder eine Bildverarbeitung ermittelt wurden.

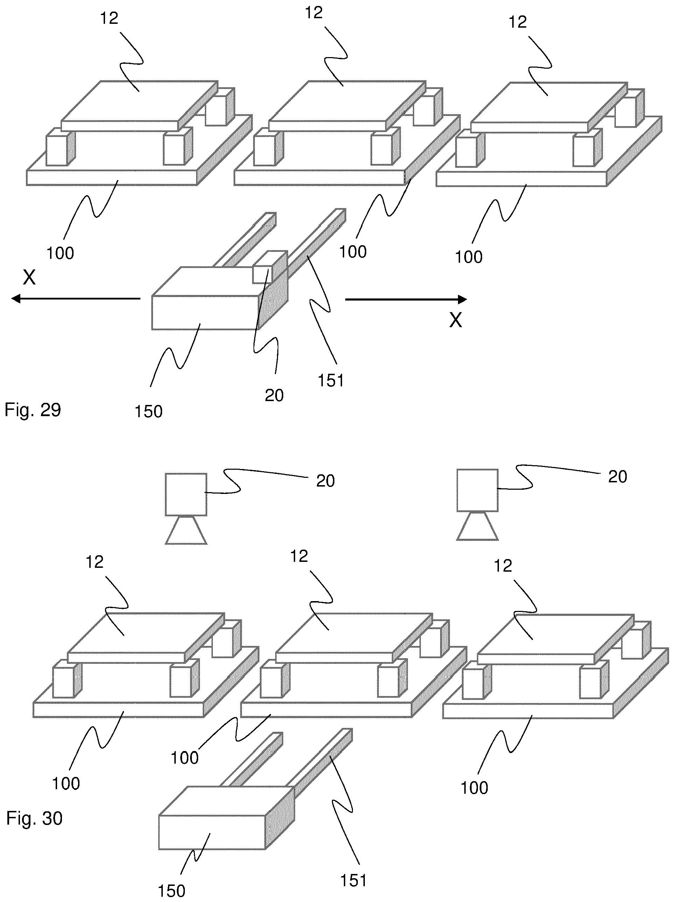

Wenn das Bildfeld 280 der Kamera nicht ausreicht, um beispielsweise sämtliche Ablagen 100 zu erfassen, kann auch ein Suchlauf durchgeführt werden. Aus der bekannten Position des Roboters und der Position von Objekten im Bild können dann beispielsweise alle Ablagen 100 in einer Maschine der Halbleiterindustrie in der Position erfasst werden, und beispielweise mehrere Ablagen 100 zumindest teilweise automatisch trainiert werden. In dem Ausführungsbeispiel der Fig. 29 sind insgesamt 3 Ablagen 100 gezeigt, welche jeweils mit einem Substrat 12, im Beispiel je einer Maske 12, bestückt sind. Der Endeffektor 150 kann zur Vergrößerung des Bildbereiches in die mit "X" gekennzeichneten Richtungen bewegt werden, um das Bildfeld 280 in dieser Ausrichtung zu vergrößern.

Wie in Fig. 30 schließlich gezeigt, kann die Aufnahmeeinheit 20, im Beispiel eine bildgebende Kamera, kann auch an anderer, beispielsweise an nicht veränderlicher Stelle in einer Maschine der Halbleiterindustrie angebracht werden. Es können auch mehrere Kameras angebracht werden, deren Bilder zusammengesetzt und dann mittels des künstlichen neuronalen Netzes ausgewertet werden, oder deren Bilder einzeln mit Hilfe des künstlichen neuronalen Netzes ausgewertet werden, woraufhin dann die Ergebnisse der Auswertung miteinander verbunden werden. Dabei können die Aufnahmeeinheiten 20 die Objekte und/oder den Roboter im Bildfeld haben.

### Bezugszeichenliste:

- 1: Handlingsystem
- 4: Ablage
- 6: Tablet
- 8a, 8b: Ansicht
- 9: Beleuchtung

- 10: Speicher
- 11: Ablageort
- 12: Substrat
- 13: Pellicle
- 16: Ecke
- 17: Einbuchtung

- 20: Aufnahmeeinheit
- 21: Bildbereich

- 30: Gesamtbild
- 31a-31f: Slot-Bilder

- 40: Rechnerarchitektur
- 41: Kabel
- 50: Beleuchtungseinheit

- 80: Maschine
- 81: Endeffektor
- 82: Roboter
- 83: Roboter-Controller
- 84: Rechnerarchitektur im Roboter-Handlingsystem
- 85: Systemcontroller
- 86: Rechnerarchitektur der Maschine der Halbleiterindustrie
- 87: Steuerung
- 88: Rechner
- 89: Cloud
- 90: Weitere Komponente der Maschine
- 91: Roboter-System

- 100: Auflage
- 101: Aufnahmepunkte
- 102: Vorderseite der Auflage

- 110: diskreter Bereich einer Bilderkennung

- 120: Bildausschnitt
- 121: Substrat in Fehllage ("cross-slotted")
- 122: Substrat in Fehllage ("double-slotted")

- 130: Bildausschnitt

- 150: Endeffektor
- 151: Greifarm des Endeffektors

- 160: Ablage
- 161a, 161b: Kamera
- 162a, 162b: Greifarm

- 170: Kameragehäuse

- 200: Maschine
- 212: Roboter
- 213: Bearbeitungsstation
- 214: Inspektionsgerät
- 218: Bühne (Stage)
- 219: Platte
- 220: Isolator
- 240a, 240b: Bild

- 250: Bildfeld
- 251: Auswertebereich
- 251a, 251b: Auswertebereich

- 280: Bildfeld
- 281a-281d: gefundene Objekte mit Bounding-Box
- 282: Markierung

## Patentansprüche

1. Verfahren zur Kontrolle oder Steuerung von Handlingsystemen (1), wobei das Handlingsystem (1) vorzugsweise einen Roboter (82) oder ein bewegliches Element, bevorzugt einen Roboterarm und/oder einen Endeffektor (81), umfasst und/oder eine Verfahreinheit, und wobei das Handlingsystem (1) vorzugsweise ferner Mittel zum Greifen, Transportieren und/oder Ablegen eines Substrates (12) aufweist,
wobei mindestens ein Bild, welches einen Ort in oder an dem Handlingsystem (1) oder in der Umgebung des Handlingsystems (1) darstellt, in digitalisierter Form
von einem künstlichen neuronalen Netz erfasst wird,
und wobei durch das künstliche neuronale Netz das Bild analysiert und ein Informationsdatensatz und/oder ein Steuerbefehl erzeugt wird, mit welchem
das Handlingsystem (1) direkt oder unterstützend gesteuert, ausgerichtet, trainiert, und/oder kontrolliert wird, und/oder wobei dieser Informationsdatensatz dazu verwendet wird, das Handlingsystem (1) auszurichten, zu trainieren oder zu kontrollieren.

2. Verfahren nach einem der vorstehenden Ansprüche, wobei das zumindest eine Bild mit einer Aufnahmeeinheit aufgenommen und/oder aus einer Datenbank dem künstlichen neuronalen Netz zugeführt wird.

3. Verfahren nach einem der vorstehenden Ansprüche, wobei das künstliche neuronale Netz mindestens ein Modell ausbildet, welches mindestens eine Faltungsebene (Convolutional Layer) und/oder mindestens eine Neuronenebene (Neuronal Layer) umfasst, und weitere Bestandteile, beispielsweise Aktivierungslayer, umfassen kann, und wobei das künstliche neuronale Netz angelernt werden kann, und/oder angelernte Daten aus einem vorangegangene Lernvorgang verwendet, und/oder wobei das künstliche neuronale Netz zumindest eine der Methoden der Regression, Machine-Learning oder Deep-Learning verwendet.

4. Verfahren nach einem der vorstehenden Ansprüche, wobei
der Informationsdatensatz eine Information
über die Präsenz oder Position oder Orientierung eines Objektes im Bild,
oder über die Art des Objektes im Bild, insbesondere das Vorhandensein von Auflagen (100), Kassetten, oder von Teilen, oder von Markierungen, Aufklebern, Beschriftungen oder Referenzmarken,
oder über mögliche Hindernisse im Bewegungsbereich des Handlingsystems (1) wie Türen
oder Loadlocks,
oder über das Vorhandensein von Bearbeitungsstationen
oder über den Abstand zwischen zumindest einem Objekt im Bild zu einem Bezugspunkt des Handlingsystems (1),
oder über die Position des Objektes im Bild,
oder über die Abmessung des Objektes im Bild umfasst, wobei die Objekte auch Substrate (12) oder Teile von Substraten (12) sein können.

5. Verfahren nach einem der vorstehenden Ansprüche, wobei der Informationsdatensatz und/oder der Steuerbefehl von der Steuerung des Handlingsystems (1) verwendet wird,
oder an ein übergeordnetes Steuerungssystem weitergegeben wird,
oder an einen Bediener weitergegeben wird, der aus dieser Information Rückschlüsse für sein Handeln zur Bedienung des Handlingsystems (1) zieht, oder diese Information an Steuerungen oder andere Bediener weitergibt,
oder an eine Anzeigevorrichtung weitergegeben wird,
oder für spätere oder weitere Auswertungen gespeichert wird.

6. Verfahren nach einem der vorstehenden Ansprüche, wobei zur Bestimmung der Position und/oder der Orientierung und/oder des Abstands und/oder der Abmessung des Objektes geometrische Verfahren, bevorzugt Verfahren der Triangulation, eingesetzt werden, wobei Daten des vom angelernten künstlichen Neuronalen Netz erzeugten Informationsdatensatzes verwendet werden, und wobei vorzugsweise nach Analyse durch das künstliche neuronale Netz in einem weiteren zweiten Schritt mindestens ein durch das künstliche neuronale Netz ermitteltes Merkmal mittels eines weiteren Verfahrens der Bilderkennung zu analysiert wird, umfassend eine regelbasierende Bildverarbeitung oder eine Kantenerkennung, oder wobei der zweite Schritt die Auswertung der Information eines zusätzlichen Sensors ist.

7. Verfahren nach einem der vorstehenden Ansprüche, wobei durch das künstliche neuronale Netz vorgesehene Lagen oder Fehllagen eines Objektes, insbesondere eines Substrates, erkannt werden, und/oder Hindernisse in der Bewegungsbahn des Handlingsystems (1), und wobei vorzugsweise zumindest zwei Bilder von unterschiedlichen Aufnahmeeinheiten (20) und/oder unterschiedlich angeordneten Aufnahmeeinheiten (20) verwendet werden.

8. Verfahren nach einem der vorstehenden Ansprüche, wobei das zumindest eine Bild durch mindestens eine dauerhaft fest oder zeitweise fest in das Handlingsystem (1) integrierte, und/oder an dem Handlingsystem (1) oder im Umfeld des Handlingsystems (1) angeordnete Aufnahmeeinheit (20) erzeugt wird, und wobei die Aufnahmeeinheit (20) einen optischen Sensor, einen Ultraschall-Sensor, einen Abstands-Sensor, einen Reflex-Sensor, ein Radar-Sensor, eine bildgebende Kamera (161a, 161b) oder Video-Kamera, oder eine Infrarotkamera umfasst.

9. Verfahren nach einem der vorstehenden Ansprüche, wobei die mindestens eine Aufnahmeeinheit (20) in Bezug auf das Handlingsystem (1) ortsunveränderlich installiert ist, und/oder wobei mindestens eine Aufnahmeeinheit (20) an beweglichen Elementen des Handlingsystems (1) befindet, bevorzugt an einem Roboterarm oder an einem Endeffektor eines Roboters (82) oder an einer Verfahreinheit.

10. Verfahren nach einem der vorstehenden Ansprüche, wobei zwei Aufnahmeeinheiten (20), insbesondere zwei Kameras (161a, 161b), vorgesehen sind, welche sich vorne an einem Endeffektor befinden, wobei die optischen Achsen der beiden Aufnahmeeinheiten (20) parallel oder in einem Winkel zueinander stehen, welcher zwischen 5° und 90°, bevorzugt zwischen 10° und 80° und besonders bevorzugt zwischen 15° und 75° beträgt.

11. Verfahren nach einem der vorstehenden Ansprüche, wobei eine Beleuchtungseinrichtung (50) vorgesehen ist, welche dazu ausgebildet ist, elektromagnetische Strahlung in Richtung auf das Substrat oder den Ort in oder an der Maschine zu emittieren, vorzugsweise wenn ein Bild erfasst wird, wobei die elektromagnetische Strahlung bevorzugt zumindest im sichtbaren Wellenlängenbereich liegt und/oder in einem Wellenlängenbereich, in dem die Aufnahmeeinheit (20) sensitiv ist, und wobei die Beleuchtungseinrichtung (50) vorzugsweise in die Maschine (80) dauerhaft fest oder zeitweise fest integriert und/oder an der Maschine (80) angebaut ist, wobei die Beleuchtungseinrichtung (50) in Bezug auf die Maschine (80) ortsunveränderlich installiert ist, und/oder sich an beweglichen Elementen der Maschine (80) befindet, bevorzugt an einem Roboterarm oder an einem Endeffektor eines Roboters (82) oder an einer Verfahreinheit.

12. Verfahren nach einem der vorstehenden Ansprüche, wobei das künstliche neuronale Netz in eine Verarbeitungseinheit als Komponente einer Rechnerarchitektur aufgenommen ist, und wobei die Rechnerarchitektur ferner zumindest eine Komponente für Rechner-Hardware und für ein Betriebssystem des Rechners umfasst, wobei vorzugsweise zumindest eine dieser Komponenten in einem System-Controller der Maschine der Halbleiterindustrie integriert sind
oder in einen Roboter (82) oder in einem Endeffektor (81) eines Roboters (82),
oder in einem Roboter-Controller,
oder in einer zur Maschine (80) übergeordneten Steuerung,
oder in einer der Maschine (80) nicht zugeordneten Steuerung, bevorzugt in einer Cloud,
oder ein einem anderen Rechner an einem beliebigen weltweiten Standort.

13. Verfahren nach dem vorstehenden Anspruch, wobei zumindest die Komponenten Verarbeitungseinheit, Rechner-Hardware und Betriebssystem an zumindest zwei verschiedenen Stellen angeordnet ist, und wobei
das künstliche neuronale Netz und/oder die Anwendung des künstlichen neuronalen Netzes über mehr als einen dieser Stellen verteilt ablaufen, oder
wobei das Trainieren des künstlichen neuronalen Netzes auf einer anderen, weiteren Rechnerarchitektur durchgeführt wird als die Anwendung des künstlichen neuronalen Netzes.

14. Verfahren zum Bereitstellen eines angelernten oder trainierten künstlichen neuronalen Netzes zur Verwendung in einem Verfahren nach einem der vorstehenden Ansprüche, umfassend die Schritte:
Bereitstellen einer Verarbeitungseinheit, welche zumindest ein künstliches neuronales Netz aufweist oder umfasst,
Trainieren des künstlichen neuronalen Netzes durch Erfassen und Bereitstellen von zumindest einem Bild, bevorzugt einer Vielzahl von wenigstens 20 Bildern, wenigstens 100, besonders bevorzugt wenigstens 1.000 Bildern.

15. Verfahren zum Bereitstellen eines angelernten oder trainierten künstlichen neuronalen Netzes nach vorstehendem Anspruch, wobei eine Vielzahl von wenigstens zwei Bildern für das Trainieren und Anlernen erfasst und/oder bereitgestellt werden, welche sich in der Ausprägung zumindest eines Parameters oder Einflussfaktors unterscheiden, und/oder wobei während der Anwendung des künstlichen neuronalen Netzes Bilder erfasst und gespeichert werden, um diese in mindestens einem initialen oder mindestens einem neuen Lernprozess zur Verbesserung des Ergebnisses des künstlichen neuronalen Netzes zu verwenden.

16. Handlingsystem (1), System oder Maschine (80) zur Bearbeitung von Substraten (12) in der Halbleiterindustrie, insbesondere von Wafern, Masken oder Flat Panel Displays, ausgebildet zur Ausführung eines Verfahrens nach einem der vorstehenden Ansprüche, vorzugsweise umfassend:
ein Handlingsystem, insbesondere ein Roboter, ein bewegliches Element, bevorzugt ein Roboterarm und/oder ein Endeffektor, oder eine Verfahreinheit,
eine Verarbeitungseinheit, welche zumindest ein trainiertes künstliches neuronales umfasst, und
eine Aufnahmeeinheit zum Erfassen zumindest eines Bildes.

17. Computerprogrammprodukt, welches direkt in einem Speicher einer Verarbeitungseinheit des Systems nach einem der beiden vorstehenden Ansprüche ladbar ist, mit Programmcode-Mitteln, um ein Verfahren nach einem der Ansprüche 1 bis 15 auszuführen, wenn das Computerprogrammprodukt in der Verarbeitungseinheit ausgeführt wird.
